# EUROPEAN PATENT SPECIFICATION

(11) **EP 3 130 465 B1**
(45) Date of publication and mention of the grant of the patent: **13.05.2020**
(21) Application number: 15180688.2
(22) Date of filing: 12.08.2015
(51) Int. Cl.: B41C 1/10, C09B 23/01

(54) **HEAT-SENSITIVE LITHOGRAPHIC PRINTING PLATE PRECURSOR**
WÄRMEEMPFINDLICHER LITHOGRAFIEDRUCKPLATTENVORLÄUFER
PRÉCURSEUR DE PLAQUE D'IMPRESSION LITHOGRAPHIQUE THERMOSENSIBLE

(43) Date of publication of application: 15.02.2017
(73) Proprietor: AGFA NV, 2640 Mortsel (BE)
(72) Inventor: Loccufier, Johan, 2640 Mortsel (BE); Desmet, Tim, 2640 Mortsel (BE)
(74) Representative: Vanderstede, Els

(56) References cited:
- EP-A1- 1 093 934
- EP-A1- 1 396 338
- EP-A1- 2 690 495
- EP-A2- 1 275 497
- WO-A1-2010/031758
- WO-A1-2010/079020
- JP-A- 2003 307 844
- US-A1- 2003 170 559

## Description

### FIELD OF THE INVENTION

The present invention relates to a positive working lithographic printing plate precursor which includes a novel IR-dye which provides a plate with reduced ablation upon exposure to heat and/or light.

### BACKGROUND OF THE INVENTION

Lithographic printing typically involves the use of a so-called printing master such as a printing plate which is mounted on a cylinder of a rotary printing press. The master carries a lithographic image on its surface and a print is obtained by applying ink to said image and then transferring the ink from the master onto a receiver material, which is typically paper. In conventional lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Lithographic printing masters are generally obtained by the image-wise exposure and processing of an imaging material called plate precursor. The coating of the precursor is exposed image-wise to heat or light, typically by means of a digitally modulated exposure device such as a laser, which triggers a (physico-)chemical process, such as ablation, polymerization, insolubilization by cross-linking of a polymer or by particle coagulation of a thermoplastic polymer latex, solubilization by the destruction of intermolecular interactions or by increasing the penetrability of a development barrier layer. Although some plate precursors are capable of producing a lithographic image immediately after exposure, the most popular plate precursors require wet processing since the exposure produces a difference of solubility or of rate of dissolution in a developer between the exposed and the non-exposed areas of the coating. In positive working plates, the exposed areas of the coating dissolve in the developer while the non-exposed areas remain resistant to the developer. In negative working plates, the non-exposed areas of the coating dissolve in the developer while the exposed areas remain resistant to the developer. Most plates contain a hydrophobic coating on a hydrophilic support, so that the areas which remain resistant to the developer define the ink-accepting, printing areas of the plate while the hydrophilic support is revealed by the dissolution of the coating in the developer at the non-printing areas.

Many lithographic printing plates contain polymeric binders such as phenolic resins which can be baked in order to increase the press life. Over the last few years, printing plate materials which provide a high press life without baking have become more popular because the post-bake oven can be eliminated leading to reduced energy consumption and less floor space. The trend towards higher printing speeds on web presses and the use of recycled paper require plate coatings that are characterised by a high abrasion resistance. Unbaked phenolic resins such as novolac, resol or poly(vinyl phenol) have a poor abrasion resistance and cannot provide a high press life under such conditions.

In the prior art, the press life of lithographic printing plates based on phenolic resins has been improved by chemical modification of such binders. Examples thereof are described in for example WO 99/01795, EP 934 822, EP 1 072 432, US 3,929,488 and EP 2 102 446. Phenolic resins have also been mixed with or replaced by other polymers such as poly(vinyl acetal) resins in order to improve the abrasion resistance of the coating. Suitable poly(vinyl acetal) resins are described in US 5,262,270; US 5,169,897; US 5,534,381; US 6,458,511; US 6,541,181; US 6,087,066; US 6,270,938; WO 2001/9682; EP 1 162 209; US 6,596,460; US 6,458,503; US 6,783,913; US 6,818,378; US 6,596,456; WO 2002/73315; WO 2002/96961; WO 2003/79113; WO 2004/20484; WO 2004/81662; EP 1 627 732; WO 2007/17162; WO 2008/103258; US 6,255,033; WO 2009/5582; WO 2009/85093; WO 2001/09682; US 2009/4599; WO 2009/99518; US 2006/130689; US 2003/166750; US 5,330,877; US 2005/3296; WO 2007/3030; US 2009/0291387; US 2010/47723 and US 2011/0059399.

With the so-called thermal digital plates, an infrared laser is used to image infrared radiation sensitive precursors. These infrared radiation sensitive precursors have as a common ingredient a compound that triggers the imaging mechanism by absorbing and converting the infrared radiation, which is used to image the precursors, into heat. Such compounds are often dyes, commonly referred to as IR-dyes. It has been observed that such IR-dyes, present as major ingredients in the coating of the precursors, also can have a negative impact on the performance of these precursors. For example, it has been observed that IR-dyes may be inhomogeneously distributed or even form aggregates in the coating of a printing plate due to their poor solubility in common coating solvents. Such aggregates may tend to form so-called hot spots in the coating leading to unwanted partial ablation. The generation of ablation debris may contaminate the electronics and optics of exposure devices.

Solutions to solve this ablation problem are provided in the art by optimizing the coating composition so that a minimum of ablation during exposure to high-power infrared laser light occurs. The Japanese Patent Applications JP 2008-197566 and JP 2008-509245 disclose for the purpose of inhibiting ablation an image recording layer including a binder having a specific structure. JP 2003-156850 discloses a barrier layer provided on the image recording layer to prevent ablation, however, such a barrier layer delays penetration of the developer into the image recording layer and so reduces the developability of the coating.
JP 2005-99631 discloses that a specific binder capable of improving film properties inhibits ablation of the image recording layer wherein it is used. However, due to the improved film properties, the permeability of a developer in the non-image portion is suppressed and therefore, also here the developability of the coating is deteriorated.

US 2013/0029268 discloses an image recording layer capable of inhibiting ablation combined with an excellent printing durability and developability, containing an infrared absorber and a copolymer containing a repeating unit having a zwitterionic structure in a side chain and a repeating unit having a hetero alicyclic structure in the main chain.

US2003/0170559 discloses a printing plate precursor comprising an image forming layer containing a macromolecular compound having a structural unit derived from a monomer which includes at least one fluorine atom.

EP 1 275 497 discloses a positive printing plate precursor including a support having disposed thereon a lower thermosensitive layer and an upper thermosensitive layer containing both a water-insoluble but alkali soluble polymer compound and (i) an IR absorbing dye with a ratio of the concentration in the upper to the lower thermosensitive layer is 1.6 to 10.0; (ii) the upper thermosensitive layer and the lower thermosensitive layer contain different IR absorbing dyes; or (iii) at least one layer contains an I R absorbent having, in one molecule, at least two covalently bonded chromophoric groups that absorb IR light.

EP 1 396 338 discloses a printing plate precursor comprising a coating including an infrared light absorbing cyanine dye which provide high sensitivity and low dye stain after processing. The dye contains a bridged methine chain and contains three to five groups which are anionic or which become anionic in an aqueous alkaline solution having a pH of at least 9.

JP2003/307844 relates to a printing plate sensitive to IR radiation and which contains a specified infrared absorbing compound. The printing plate has a high sensitivity and press-life.

WO 2010/079020 discloses a lithographic printing plate precursor comprising a coating containing thermoplastic polymer particles and an IR-dye which contains an annulated ring structural element which provides an improved daylight stability to the coating.

EP 1 093 934 discloses a positive type planographic printing plate including a photosensitive composition of which the development latitude, the image recording properties and storage stability are improved by using a specific infrared absorbing agent.

WO2010/031758 discloses a lithographic printing plate precursor comprising a coating containing thermoplastic polymer particles and an infrared radiation absorbing compound which contains a bromo and/or iodo substituent. The lithographic printing plate precursor is characterized by an increased sensitivity and an improved clean-out behaviour.

Although many attempts have been made in the prior art to provide printing plates in which ablation is reduced and/or inhibited, the formation of ablation debris during laser exposure is still a major concern in the art.

### SUMMARY OF THE INVENTION

It is an aspect of the present invention to provide a positive-working lithographic printing plate precursor wherein the coating is optimized for producing a minimum extent of ablation when exposed to heat and/or light. This object is realized by the material of claim 1, i.e. a positive-working lithographic printing plate precursor comprising a coating including an infrared absorbing compound, characterized in that the infrared absorbing compound has a structure according to Formula IV: 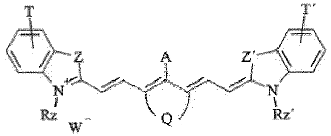 wherein
A represents -S-R¹ wherein R¹ represents an optionally substituted alkyl, aralkyl, alkaryl, cycloalkyl, alkenyl, alkynyl, aryl or heteroaryl group, and/or combinations thereof;
and wherein the alkyl, aralkyl, alkaryl, cycloalkyl, alkenyl, alkynyl, aryl or heteroaryl group is substituted with a thioalkyl group, a thioaryl group, thioheteroaryl, -SH or a thioether group;
Q = -CHR'-CHR"-, -CR'-CR"- or CHR' -CER"-CHR'" - and R', R" and R"' independently represent hydrogen, an alkyl, cycloalkyl, aralkyl, alkaryl, aryl or heteroaryl group, or R'and R" or R" and R"'form together a cyclic structure;
T and T' independently represent hydrogen, alkyl, halogen, alkoxy cyano, -CO₂Rⁿ, -CONR^{k}R^{m}, -SO₂Rⁿ, -SO₂HR^{o}R^{p} or an optionally substituted annulated benzo ring wherein R^{k}, R^{m} represent hydrogen, an optionally substituted alkyl or aryl group, Rⁿ represents an optionally substituted alkyl or aryl group and R^{o} and R^{P} represent hydrogen, an optionally substituted alkyl or aryl group;
R^{z} and R^{z'} independently represent an optionally substituted alkyl group;
Z and Z' independently represent -S-, -CH=CH- or -CR^{a}R^{b}-;
R^{a} and R^{b} represent an optionally substituted, alkyl, aralkyl, alkaryl or aryl group; and
W⁻ renders the chromophoric group neutral .

Other features, elements, steps, characteristics and advantages of the present invention will become more apparent from the following detailed description of preferred embodiments of the present invention. Specific embodiments of the invention are also defined in the dependent claims.

### DETAILED DESCRIPTION OF THE INVENTION

The lithographic printing plate precursor according to the present invention comprises a heat and/or light sensitive coating on a support and is positive-working, i.e. after exposure and development the exposed areas of the coating are removed from the support and define hydrophilic (non-printing) areas, whereas the unexposed coating is not removed from the support and defines oleophilic (printing) areas.

The infrared absorbing compound, also referred to herein as IR-absorbing compound or IR-dye, absorbs infrared (IR) radiation light and converts the absorbed energy into heat. The IR-dye preferably includes a conjugated system also referred to as "chromophoric moiety". The chromophoric moiety has its main absorption in the infrared region, i.e. radiation having a wavelength in the range from 750 to 1500 nm, preferably in the range from 750 nm to 1250 nm, more preferably in the range from 750 nm to 1100 nm, and most preferably in the range from 780 nm to 900 nm. Preferably the chromophoric group has its absorption maximum in the infrared region.

Suitable examples of IR-dyes include, but are not limited to, polymethyl indoliums, metal complex IR dyes, indocyanine green, polymethine dyes, croconium dyes, cyanine dyes, merocyanine dyes, squarylium dyes, chalcogenopyryloarylidene dyes, metal thiolate complex dyes, bis(chalcogenopyrylo) polymethine dyes, dyes including a barbituric group, oxyindolizine dyes, bis(aminoaryl)polymethine dyes, indolizine dyes, metal dithioline dyes, pyrylium dyes, quinoid dyes, quinone dyes, phthalocyanine dyes, naphthalocyanine dyes, azo dyes, (metalized) azomethine dyes and combinations thereof. Preferred dyes include squarylium, croconium, merocyanine, cyanine, indolizine, pyrilium or metal dithioline dyes. Most preferred IR-dyes are cyanine dyes and contain a structural element according to Formula I: 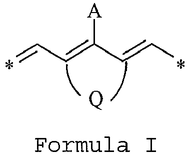 wherein A represents -S-R¹ and R¹ represents an optionally substituted alkyl, aralkyl, alkaryl, cycloalkyl, alkenyl, alkynyl, aryl, or heteroaryl group, and/or combinations thereof and Q = -CHR'-CHR"-, -CR'=CR"- or -CHR'-CHR"-CHR"'- and R', R" and R"' independently represent hydrogen, an alkyl, cycloalkyl, aralkyl, alkaryl, aryl or heteroaryl group, or R' and R" or R" and R"' form together a cyclic structure.

In the definition of A, R¹ preferably represents an optionally substituted alkyl, aryl or heteroaryl group, or combinations thereof, a heteroaryl group being most preferred. Most preferably, R¹ represents an optionally substituted heteroaryl group derived from furan, thiophene, pyrrole, pyrazole, imidazole, 1,2,3-triazole, 1,2,4-triazole, tetrazole, oxazole, isoxazole, thiazole, isothiazole, thiadiazole, oxadiazole, pyridine, pyridazine, pyrimidine, pyrazine, 1,3,5-triazine, 1,2,4-triazine or 1,2,3-triazine. All these compounds may be annulated such as benzofuran, benzothiophene, indole, indazole, benzoxazole, quinoline, quinazoline, benzimidazole or benztriazole.

The heteroaryl group is preferably represented by Formula II: 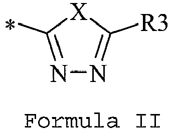
wherein * indicates the linking position to S.
and X represents NR² , S or O; wherein R² represents hydrogen, an optionally substituted alkyl, cycloalkyl, alkenyl, alkaryl, aralkyl, aryl, heteroaryl or heteroalicyclic group, or combinations thereof; and R³ represents hydrogen, an optionally substituted alkyl, alkenyl, S-R⁴, aralkyl, alkaryl, aryl or heteroaryl group, or combinations thereof.

The heteroaryl group is most preferably represented by Formula III: 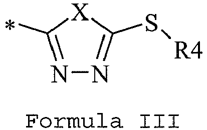
wherein X is S, O or NR², preferably X= S or O;
and R⁴ represents hydrogen, an optionally substituted alkyl, cycloalkyl, alkenyl, alkynyl, aralkyl, alkaryl, aryl, heteroaryl or heteroalicyclic group and/or combinations thereof.

According to the present invention, the IR-absorbing compound is cationic and has a structure according to Formula IV: 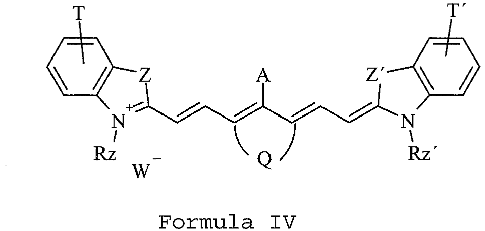 wherein A, Q, T, T', R^{z}, R^{z} ,Z, Z', R^{a}, R^{b} and W^{~} are as defined in the Formula IV above.

Preferably Z and Z' independently represent -CR^{a}R^{b}-wherein R^{a} and R^{b} independently represent an optionally substituted alkyl, alkaryl, aralkyl or aryl group. Most preferably R^{a} and R^{b} independently represent an optionally substituted alkyl group; most preferably R^{a} and R^{b} represent a methyl or ethyl group. T and T' preferably independently represent hydrogen or an alkyl group such as methyl or ethyl. R^{z} and R^{z'} preferably represent a C¹ to C¹⁰ alkyl group more preferably a C¹ to C⁵ alkyl group such as a methyl, ethyl, propyl or butyl group, most preferably a butyl group.

The infrared absorbing dye more preferably has a structure according to Formula V: 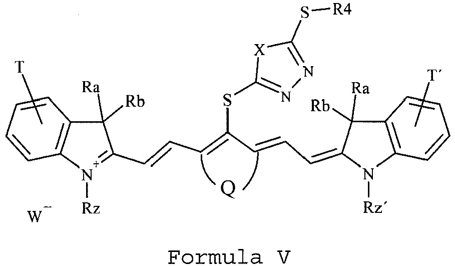 wherin Q, T, T', R^{z}, R^{z'}, W⁻, R⁴, R^{a} and R^{b} are as defined in the above Formulae and X= O or S.

In a preferred embodiment, in Formulae I to V above, Q represents -CHR^{Y}-CHR^{y'}-, -CR^{y}=CR^{y'}- or -CH₂-CH₂-CH₂- and the structural element including Q is preferably represented by Formulae VI, VII or VIII: 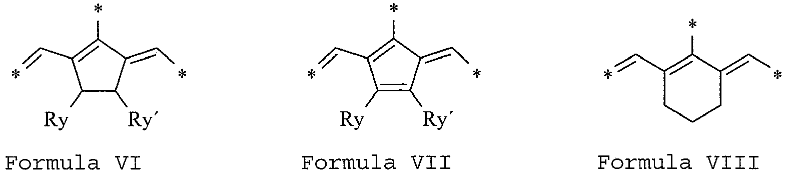 wherein
R^{y} and R^{y'} independently represent hydrogen, an optionally substituted alkyl, aralkyl, alkaryl or aryl group or represent the necessary atoms to form a cyclic structure. Preferably, in Formula VI, R^{y} and R^{y'} independently represent hydrogen or an optionally substituted alkyl group; and in Formula VII R^{y} and R^{y'} preferably represent an annulated ring, preferably as presented by Formula IX: 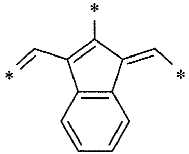 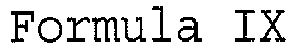 In Formulae VI to IX, * represents the linking positions to the rest of the dye.

The counterion W preferably represents a halide anion, e.g. Cl⁻ , Br⁻ or I⁻_{;} a sulfonate group anion such as a alkyl or aryl sulfonate group anion; e.g. CH₃SO₃ , CF₃SO₃ or p-toluene sulfonate; tetrafluoroborate; hexafluorophosphate or a perfluoroalkyl containing group; the perfluoroalkyl group preferably includes at least 5 fluorine atoms. The perfluoroalkyl group is most preferred and may be represented by CF₃-(CF₂)ₘ-(CH₂)ₙ-G wherein m and n independently represent 0 or an integer greater than 0, and G represents for example -SO₃⁻ , -HPO₃⁻, -HPO₄⁻ or -COO⁻. Most preferably G represents -SO₃⁻ or -COO⁻, m = 0, 1, 2 or 3 and n = 0, 1, 2 or 3.

Examples of suitable aryl groups may be represented by for example an optionally substituted phenyl, benzyl, tolyl or an ortho- meta- or para-xylyl group, an optionally substituted naphtyl, anthracenyl, phenanthrenyl, and/or combinations thereof. Unless otherwise defined, the heteroaryl group herein is preferably a monocyclic or polycyclic aromatic ring comprising carbon atoms and one or more heteroatoms in the ring structure, preferably, 1 to 4 heteroatoms, independently selected from nitrogen, oxygen, selenium and sulphur. Preferred examples thereof include an optionally substituted furyl, pyridinyl, pyrimidyl, pyrazoyl, imidazoyl, oxazoyl, isoxazoyl, thienyl, tetrazoyl, thiazoyl, (1,2,3)triazoyl, (1,2,4)triazoyl, thiadiazoyl, thiofenyl group and/or combinations thereof.

Examples of suitable alkyl groups are methyl, ethyl, n-propyl, isopropyl, n-butyl, 1-isobutyl, 2-isobutyl and tertiarybutyl, n-pentyl, n-hexyl, chloromethyl, trichloromethyl, isopropyl, iso-butyl, iso-pentyl, neo-pentyl, 1-methylbutyl and isohexyl, 1,1-dimethyl-propyl, 2,2-dimethylpropyl and 2-methyl-butyl, cyclopropyl, cyclobutyl, cyclopentyl, cyclohexyl and methylcyclohexyl groups, n-butyl, , etc.

A suitable alkenyl group is preferably a C₂ to C₆-alkenyl group such as an ethenyl, n-propenyl, n-butenyl, n-pentenyl, n-hexenyl, iso-propenyl, iso-butenyl, iso-pentenyl, neo-pentenyl, 1-methylbutenyl, iso-hexenyl, cyclopentenyl, cyclohexenyl and methylcyclohexenyl group.

A suitable alkynyl group is preferably a C₂ to C₆-alkynyl group; a suitable aralkyl group is preferably a phenyl group or naphthyl group including one, two, three or more C₁ to C₆-alkyl groups; a suitable alkaryl group is preferably a C₁ to C₆-alkyl group including an aryl group, preferably a phenyl group or naphthyl group.

A cyclic group or cyclic strycture includes at least one ring structure and may be a monocyclic- or polycyclic group, meaning one or more rings fused together.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

The optional substituents on the alkyl, cycloalkyl, alkenyl, cycloalkenyl, alkynyl, aralkyl, alkaryl, aryl, heteroaryl and heterocyclic group are preferably selected from hydroxy, -Cl, - Br, -I, -OH, -SH, -CN, -NO₂, an alkyl group such as a methyl or ethyl group, an alkoxy group such as a methoxy or an ethoxy group, an aryloxy group, a carboxylic acid group or an alkyl ester thereof, a sulphonic acid group or an alkyl ester thereof, a phosphonic acid group or an alkyl ester thereof, a phosphoric acid group or an an ester such as an alkyl ester such as methyl ester or ethyl ester, a thioalkyl group, a thioaryl group, thioheteroaryl, -SH, a thioether such as a thioalkyl or thioaryl, ketone, aldehyde, sulfoxide, sulfone, sulfonate ester, sulphonamide, an amino, ethenyl, alkenyl, alkynyl, cycloalkyl, alkaryl, aralkyl, aryl, heteroaryl or heteroalicyclic group and/or combinations thereof.

Without being limited thereto, typical examples of infrared absorbing dyes according to the present invention are given below.

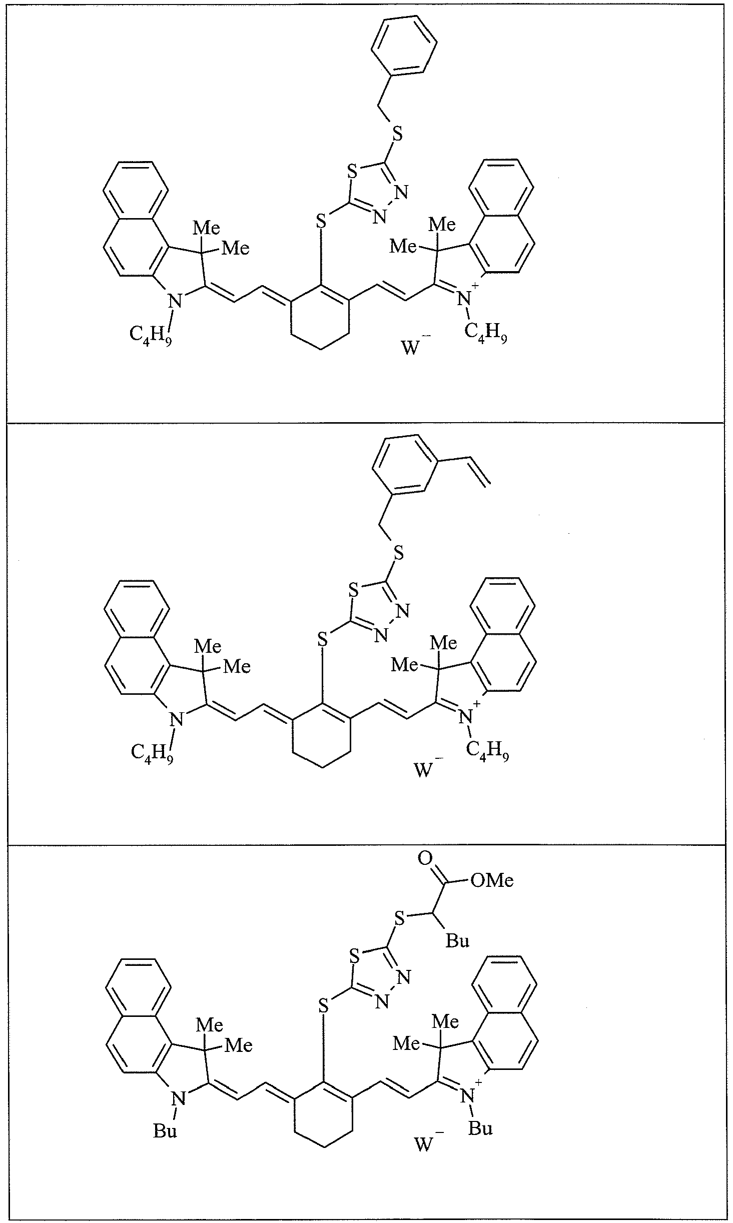

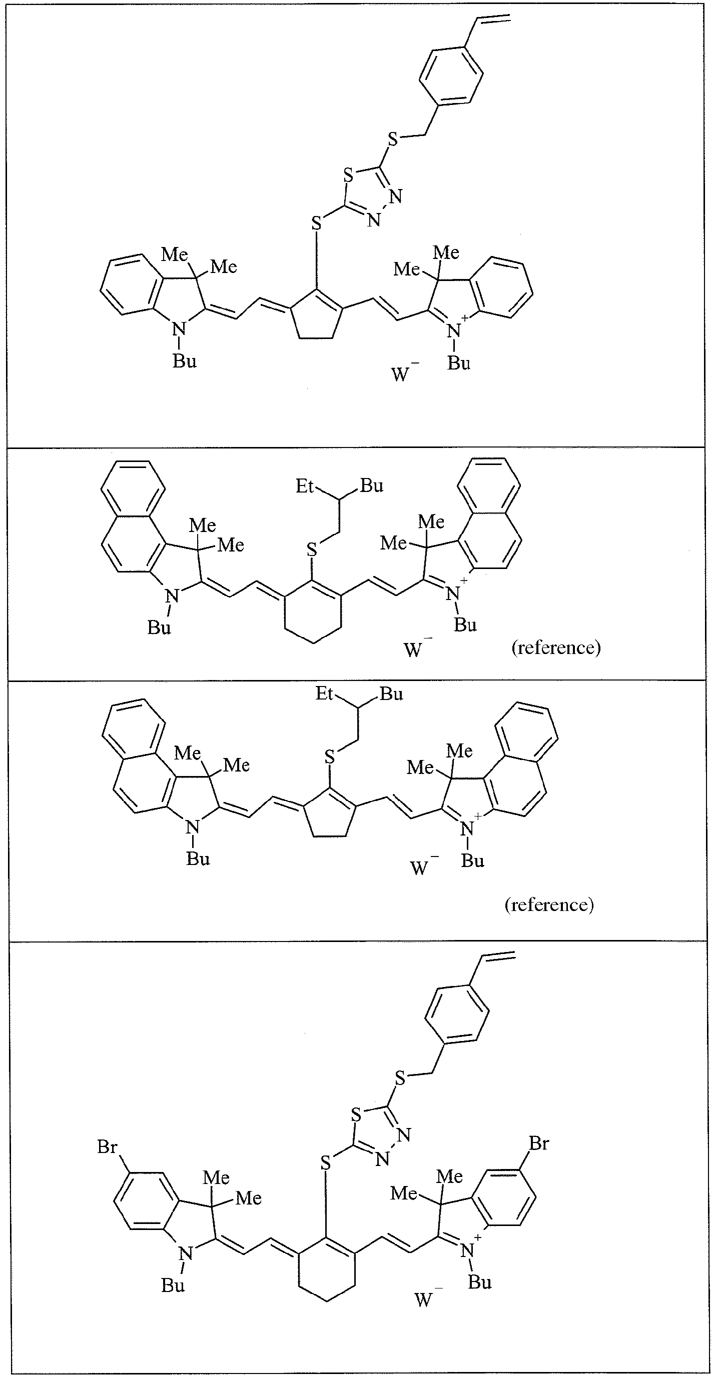

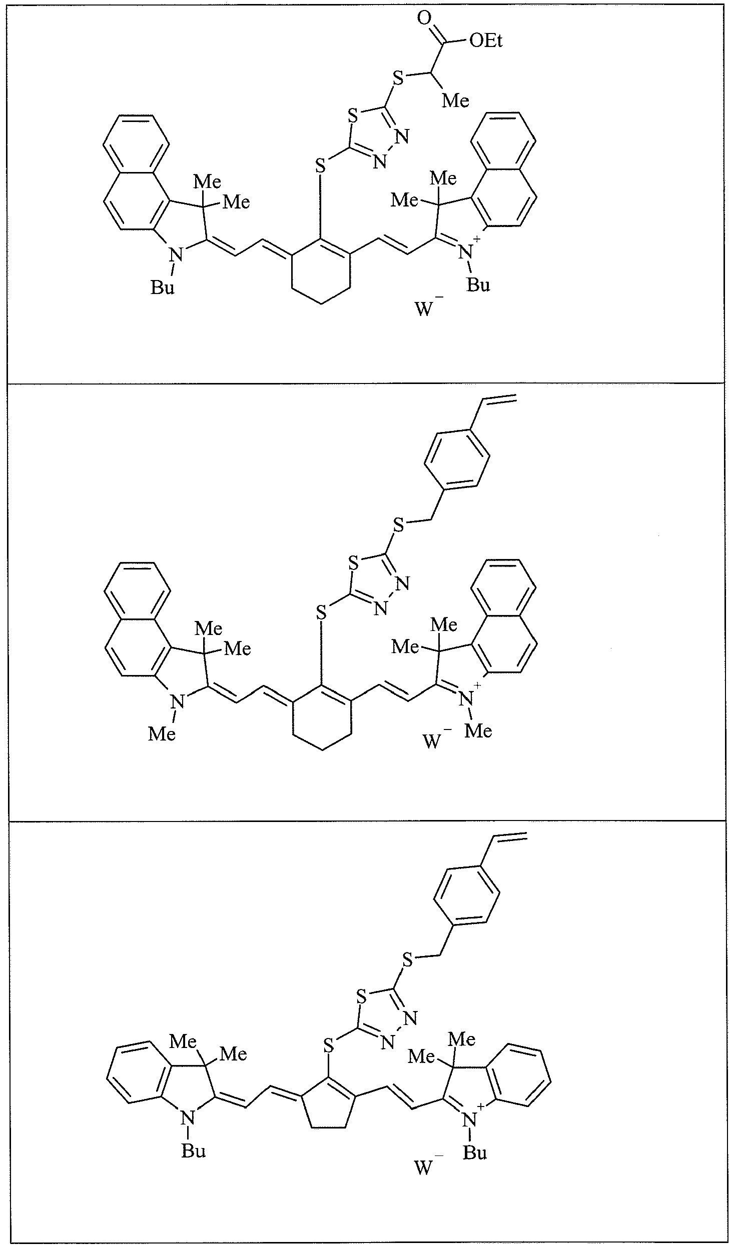

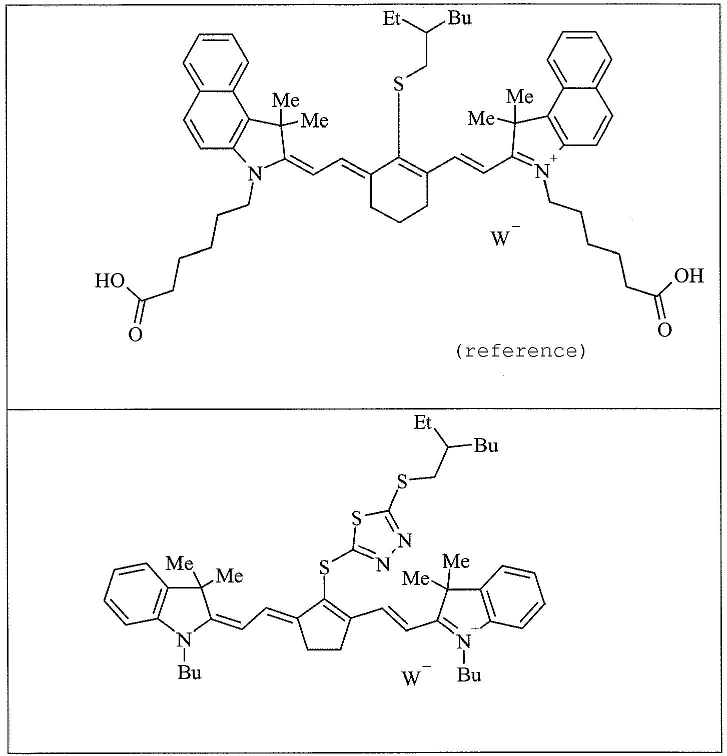

wherein counterion W⁻ is as defined above.

The light and/or heat-sensitive coating may comprise one layer or more than one layer. Preferably, the coating comprises at least two layers; a first layer, and a second layer located above said first layer. First layer means that the layer is, compared to the second layer, located closer to the lithographic support. The infrared absorbing dye of the present invention may be present in the first layer, in the second layer or in the first and the second layer. The infrared absorbing dye of the present invention is preferably only present in the second layer.

The concentration of the IR-dye of the current invention in the coating is preferably between 0.25 and 15.0 %wt, more preferably between 0.5 and 10.0 %wt, most preferably between 1.0 and 7.5 %wt relative to the coating as a whole.

The light and/or heat sensitive coating preferably contains, besides the infrared absorbing dye, an alkaline soluble oleophilic resin. The oleophilic resin present in the coating is preferably a polymer that is soluble in an aqueous developer, more preferably an aqueous alkaline developing solution with a pH between 7.5 and 14. The oleophilic resin is preferably a phenolic resin selected from a novolac, a resol or a polyvinylphenolic resin. Other preferred polymers are phenolic resins wherein the phenyl group or the hydroxy group of the phenolic monomeric unit are chemically modified with an organic substituent as described in EP 894 622, EP 901 902, EP 933 682, WO99/63407, EP 934 822, EP 1 072 432, US 5,641,608, EP 982 123, WO99/01795, WO04/035310, WO04/035686, WO04/035645, WO04/035687 or EP 1 506 858. One or more alkaline soluble oleophilic resins may be present in the coating.

The amount of phenolic resin optionally present in the coating is preferably at least 20% by weight; more preferably at least 30% by weight and most preferably at least 45% by weight; the amounts are relative to the total weight of all the components present in the coating
The novolac resin or resol resin may be prepared by polycondensation of aromatic hydrocarbons such as phenol, o-cresol, p-cresol, m-cresol, 2,5-xylenol, 3,5-xylenol, resorcinol, pyrogallol, bisphenol, bisphenol A, trisphenol, o-ethylphenol, p-etylphenol, propylphenol, n-butylphenol, t-butylphenol, 1-naphtol and 2-naphtol, with at least one aldehyde or ketone selected from aldehydes such as formaldehyde, glyoxal, acetoaldehyde, propionaldehyde, benzaldehyde and furfural and ketones such as acetone, methyl ethyl ketone and methyl isobutyl ketone, in the presence of an acid catalyst. Instead of formaldehyde and acetaldehyde, paraformaldehyde and paraldehyde may, respectively, be used. The weight average molecular weight, measured by gel permeation chromatography using universal calibration and polystyrene standards, of the novolac resin is preferably from 500 to 150,000 g/mol, more preferably from 1,500 to 50,000 g/mol.

The poly(vinylphenol) resin may be a polymer of one or more hydroxy-phenyl containing monomers such as hydroxystyrenes or hydroxy-phenyl (meth)acrylates. Examples of such hydroxystyrenes are o-hydroxystyrene, m-hydroxystyrene, p-hydroxystyrene, 2-(o-hydroxyphenyl)propylene, 2-(m-hydroxyphenyl)propylene and 2-(p-hydroxyphenyl)propylene. Such a hydroxystyrene may have a substituent such as chloro, bromo, iodo or fluoro group or a C₁₋₄ alkyl group, on its aromatic ring. An example of such hydroxy-phenyl (meth)acrylate is 2-hydroxy-phenyl methacrylate. The poly(vinylphenol) resin may be prepared by polymerizing one or more hydroxy-phenyl containing monomer in the presence of a radical initiator or a cationic polymerization initiator, or by copolymerizing of one or more of these hydroxy-phenyl containing monomers with other monomeric compounds such as acrylate monomers, methacrylate monomers, acrylamide monomers, methacrylamide monomers, vinyl monomers, aromatic vinyl monomers or diene monomers. The weight average molecular weight, measured by gel permeation chromatography using universal calibration and polystyrene standards, of the poly(vinylphenol) resin is preferably from 1.000 to 200,000 g/mol, more preferably from 1,500 to 50,000 g/mol.

The heat-sensitive coating may further contain one or more other binder(s) which is insoluble in water and soluble in an alkaline solution such as an organic polymer which preferably has acidic groups with a pKa of less than 13 to ensure that the layer is soluble or at least swellable in aqueous alkaline developers. The binder may be selected from a polyester resin, a polyamide resin, an epoxy resin, an acrylic resin, a methacrylic resin, a styrene based resin, a polyurethane resin or a polyurea resin. The binder may have one or more functional groups. The functional group(s) can be selected from the list of
(i) a sulfonamide group such as -NR-SO₂-, -SO₂-NR- or -SO₂-NR'R" wherein R and R' independently represent hydrogen or an optionally substituted hydrocarbon group such as an optionally substituted alkyl, aryl or heteroaryl group; more details concerning these polymers can be found in EP 2 159 049;
(ii) a sulfonamide group including an acid hydrogen atom such as -SO₂-NH-CO- or -SO₂-NH-SO₂- as for example disclosed in US 6,573,022; suitable examples of these compounds include for example N-(p-toluenesulfonyl) methacrylamide and N-(p-toluenesulfonyl) acrylamide;
(iii) an urea group such as -NH-CO-NH-, more details concerning these polymers can be found in WO 01/96119;
(iv) a star polymer in which at least three polymer chains are bonded to a core as described in EP 2 497 639;
(v) a carboxylic acid group;
(vi) a nitrile group;
(vii) a sulfonic acid group; and/or
(viii) a phosphoric acid group.

(Co)polymers including a sulfonamide group are preferred. Sulfonamide (co)polymers are preferably high molecular weight compounds prepared by homopolymerization of monomers containing at least one sulfonamide group or by copolymerization of such monomers and other polymerizable monomers. Preferably, in the embodiment wherein the coating includes two layers, the copolymer comprising at least one sulfonamide group is present in the first layer located between the outer most layer and the hydrophilic support.

Examples of monomers copolymerized with the monomers containing at least one sulfonamide group include monomers as disclosed in EP 1 262 318, EP 1 275 498, EP 909 657, EP 1 120 246, EP 894 622, US 5,141,838, EP 1 545 878 and EP 1 400 351. Monomers such as alkyl or aryl (meth)acrylate such as methyl (meth)acrylate, ethyl (meth)acrylate, butyl (meth)acrylate, benzyl (meth)acrylate, 2-phenylethyl (meth)acrylate, hydroxylethyl (meth)acrylate, phenyl (meth)acrylate; (meth)acrylic acid; (meth)acrylamide; a N- alkyl or N-aryl (meth)acrylamide such as N-methyl (meth)acrylamide, N-ethyl (meth)acrylamide, N-phenyl (meth)acrylamide, N-benzyl (meth)acrylamide, N-methylol (meth)acrylamide, N-(4-hydroxyphenyl)(meth)acrylamide, N-(4-methylpyridyl)(meth)acrylate; (meth)acrylonitrile; styrene; a substituted styrene such as 2-, 3-or 4-hydroxy-styrene, 4-benzoic acid-styrene; a vinylpyridine such as 2-vinylpyridine, 3-vinylpyridine, 4-vinylpyridine; a substituted vinylpyridine such as 4-methyl-2-vinylpyridine; vinyl acetate, optionally the copolymerised vinyl acetate monomeric units are at least partially hydrolysed, forming an alcohol group, and/or at least partially reacted by an aldehyde compound such as formaldehyde or butyraldehyde, forming an acetal or butyral group; vinyl alcohol; vinyl acetal; vinyl butyral; a vinyl ether such as methyl vinyl ether; vinyl amide; a N-alkyl vinyl amide such as N-methyl vinyl amide, caprolactame, vinyl pyrrolydone; maleimide; a N-alkyl or N-aryl maleimide such as N-benzyl maleimide, are preferred.

Suitable examples of sulfonamide (co)polymers and/or their method of preparation are disclosed in EP 933 682, EP 982 123, EP 1 072 432, WO 99/63407, EP 1 400 351 and EP 2 159 049. A highly preferred example of a sulfonamide (co)polymer is described in EP 2 047 988 A in [0044] to [0046].

Specific preferred examples of sulphonamide (co)polymers are polymers comprising N-(p-aminosulfonylphenyl) (meth)acrylamide, N-(m-aminosulfonylphenyl) (meth)acrylamide N-(o-aminosulfonylphenyl) (meth)acrylamide and or m-aminosulfonylphenyl (meth)acrylate.

(Co)polymers including an imide group are also preferred as a binder in the heat-sensitive coating. Specific examples include derivatives of methyl vinyl ether/maleic anhydride copolymers and derivatives of styrene/maleic anhydride copolymers, that contain an N-substituted cyclic imide monomeric units and/or N-substituted maleimides such as a N-phenylmaleimide monomeric unit and a N-benzyl-maleimide monomeric unit. Preferably, in the embodiment where the coating comprises two layers, this copolymer is present in the first layer. This copolymer is preferably alkali soluble. Suitable examples are described in EP 933 682, EP 894 622 A [0010] to [0033], EP 901 902, EP 0 982 123 A [007] to [0114], EP 1 072 432 A [0024] to [0043] and WO 99/63407 (page 4 line 13 to page 9 line 37).

Polycondensates and polymers having free phenolic hydroxyl groups, as obtained, for example, by reacting phenol, resorcinol, a cresol, a xylenol or a trimethylphenol with aldehydes, especially formaldehyde, or ketones, may also be added to the heat-sensitive coating. Condensates of sulfamoyl- or carbamoyl-substituted aromatics and aldehydes or ketones are also suitable. Polymers of bismethylol-substituted ureas, vinyl ethers, vinyl alcohols, vinyl acetals or vinylamides and polymers of phenylacrylates and copolymers of hydroxy-phenylmaleimides are likewise suitable. Furthermore, polymers having units of vinylaromatics or aryl (meth)acrylates may be mentioned, it being possible for each of these units also to have one or more carboxyl groups, phenolic hydroxyl groups, sulfamoyl groups or carbamoyl groups. Specific examples include polymers having units of 2-hydroxyphenyl (meth)acrylate, of 4-hydroxystyrene or of hydroxyphenylmaleimide. The polymers may additionally contain units of other monomers which have no acidic units. Such units include vinylaromatics, methyl (meth)acrylate, phenyl(meth)acrylate, benzyl (meth)acrylate, methacrylamide or acrylonitrile.

The dissolution behavior of the coating can be fine-tuned by optional solubility regulating components. More particularly, developability enhancing compounds, development accelerators and development inhibitors can be used. In the embodiment where the coating comprises more than one layer, these ingredients can be added to the first layer and/or to the second layer and/or to an optional other layer of the coating.

Suitable developability enhancing compounds are (i) compounds which upon heating release gas as disclosed in WO 2003/79113, (ii) the compounds as disclosed in WO 2004/81662, (iii) the compositions that comprises one or more basic nitrogen-containing organic compounds as disclosed in WO 2008/103258 and (iv) the organic compounds having at least one amino group and at least one carboxylic acid group as disclosed in WO 2009/85093.

Examples of basic nitrogen-containing organic compounds useful in the developability-enhancing compositions are N-(2-hydroxyethyl)-2- pyrrolidone, 1 -(2-hydroxyethyl)piperazine, N-phenyldiethanolamine, triethanolamine, 2-[bis(2-hydroxyethyl)amino]-2-hydroxymethyl-1.3-propanediol, N,N,N',N'-tetrakis(2-hydroxyethyl)-ethylenediamine, N,N,N',N'-tetrakis(2-hydroxypropyl)-ethylenediamine, 3-[(2-hydroxyethyl)phenylamino]propionitrile, and hexahydro-1,3,5-tris(2-hydroxyethyl)-s-triazine. Preferably N,N,N',N'-tetrakis(2-hydroxypropyl)-ethylenediamine is used. Mixtures of two or more of these compounds are also useful. The basic nitrogen-containing organic compounds can be obtained from a number of commercial sources including BASF (Germany) and Aldrich Chemical Company (Milwaukee, WI).

The basic nitrogen-containing organic compound(s) is preferably present in the coating in an amount of from 1 to 30 %wt, and typically from 3 to 15 %wt, based on the total solids of the coating composition.

Preferably, one or more of the basic nitrogen-containing organic compounds are used in combination with one or more acidic developability-enhancing compounds, such as carboxylic acids or cyclic acid anhydrides, sulfonic acids, sulfinic acids, alkylsulfuric acids, phosphonic acids, phosphinic acids, phosphonic acid esters, phenols, sulfonamides, or sulfonimides, since such a combination may permit further improved developing latitude and printing durability. Representative examples of the acidic developability-enhancing compounds are provided in [0030] to [0036] of US 2005/0214677. They may be present in an amount of from 0.1 to 30 %wt based on the total dry weight of the coating composition. The molar ratio of one or more basic nitrogen-containing organic compounds to one or more acidic developability-enhancing compounds is generally from 0.1: 1 to 10:1 and more typically from 0.5: 1 to 2: 1.

Polymeric developability enhancing compounds combined with a low molecular weight developability enhancing compound as described above are also of interest. The polymeric compound preferably has a molecular weight above 1500 g/mol and is present in an amount preferably less than 40 %wt of the total coating composition, more preferably less than 10 %wt and most preferably less than 5 %wt. The low molecular weight component preferably has a molecular weight below 1500 g/mol and is present in an amount preferably less than 10 %wt of the total weight composition, more preferably less than 5 %wt and most preferably less than 2.5 %wt. This type of contrast-enhancing system is preferably used in low pH developers, pH<12, which are substantially free of silicates.

The polymeric compound may be a derivative of a glycol such as for example polyethylenoxide, polypropyleneoxide and/or copolymers thereof, or a phenolic resin having a molecular weight lower than 100000 g/mol.

Specific examples of such high and low molecular weight developability enhancing compounds which are suitably used together are for example hyperbranched polyesters such as the Boltorn™ products commercially available from Perstorp, and the following compounds:

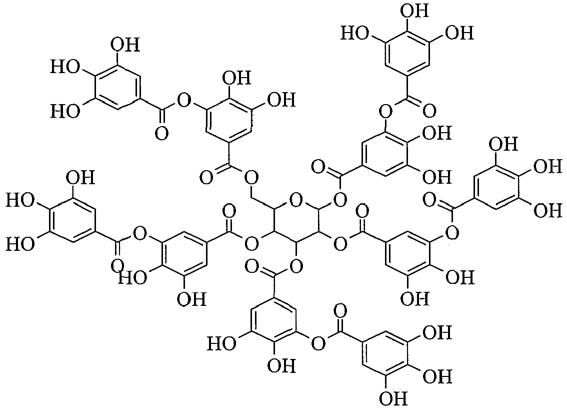

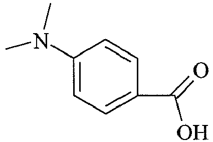

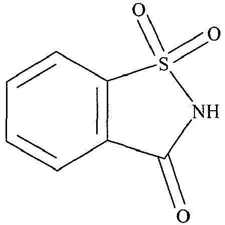

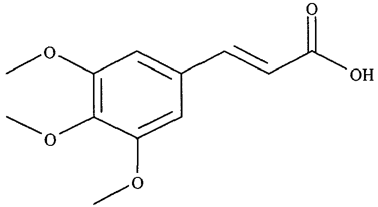

Development accelerators are compounds which act as dissolution promoters because they are capable of increasing the dissolution rate of the coating. For example, cyclic acid anhydrides, phenols or organic acids can be used in order to improve the aqueous developability. Examples of the cyclic acid anhydride include phthalic anhydride, tetrahydrophthalic anhydride, hexahydrophthalic anhydride, 3,6-endoxy-4-tetrahydro-phthalic anhydride, tetrachlorophthalic anhydride, maleic anhydride, chloromaleic anhydride, alpha -phenylmaleic anhydride, succinic anhydride, and pyromellitic anhydride, as described in U.S. Patent No. 4,115,128. Examples of the phenols include bisphenol A, p-nitrophenol, p-ethoxyphenol, 2,4,4'-trihydroxybenzophenone, 2,3,4-trihydroxy-benzophenone, 4-hydroxybenzophenone, 4,4',4"-trihydroxy-triphenylmethane, and 4,4',3",4"-tetrahydroxy-3,5,3',5'-tetramethyltriphenyl-methane, and the like. Examples of the organic acids include sulphonic acids, sulfinic acids, alkylsulfuric acids, phosphonic acids, phosphates, and carboxylic acids, as described in, for example, JP-A Nos. 60-88,942 and 2-96,755. Specific examples of these organic acids include p-toluenesulphonic acid, dodecylbenzenesulphonic acid, p-toluenesulfinic acid, ethylsulfuric acid, phenylphosphonic acid, phenylphosphinic acid, phenyl phosphate, diphenyl phosphate, benzoic acid, isophthalic acid, adipic acid, p-toluic acid, 3,4-dimethoxybenzoic acid, 3,4,5-trimethoxybenzoic acid, 3,4,5-trimethoxycinnamic acid, phthalic acid, terephthalic acid, 4-cyclohexene-1,2-dicarboxylic acid, erucic acid, lauric acid, n-undecanoic acid, and ascorbic acid. The amount of the cyclic acid anhydride, phenol, or organic acid contained in the coating is preferably in the range of 0.05 to 20% by weight, relative to the coating as a whole. Polymeric development accelerators such as phenolic-formaldehyde resins comprising at least 70 mol% metacresol as recurring monomeric units are also suitable development accelerators.

In a preferred embodiment, the coating also contains developer resistance means, also called development inhibitors, i.e. one or more ingredients which are capable of delaying the dissolution of the unexposed areas during processing. The dissolution inhibiting effect is preferably reversed by heating, so that the dissolution of the exposed areas is not substantially delayed and a large dissolution differential between exposed and unexposed areas can thereby be obtained. The compounds described in e.g. EP 823 327 and WO 97/39894 act as dissolution inhibitors due to interaction, e.g. by hydrogen bridge formation, with the alkalisoluble resin(s) in the coating. Inhibitors of this type typically are organic compounds which include at least one aromatic group and a hydrogen bonding site such as a nitrogen atom which may be part of a heterocyclic ring or an amino substituent, an onium group, a carbonyl, sulfinyl or sulfonyl group. Suitable dissolution inhibitors of this type have been disclosed in e.g. EP 825 927 and EP 823 327. Some of the compounds mentioned below, e.g. infrared dyes, such as cyanines, and contrast dyes, such as quaternized triarylmethane dyes, can also act as a dissolution inhibitor.

Other suitable inhibitors improve the developer resistance because they delay the penetration of the aqueous alkaline developer into the coating. Such compounds can be present in the first layer and/or in the optional second layer and/or in a development barrier layer on top of said layer, as described in e.g. EP 864 420, EP 950 517, WO 99/21725 and WO 01/45958. The solubility and/or penetrability of the barrier layer in the developer can be increased by exposure to heat and/or infrared light.

Water-repellent polymers represent another type of suitable dissolution inhibitors. Such polymers seem to increase the developer resistance of the coating by repelling the aqueous developer from the coating. The water-repellent polymers can be added to the coating and/or can be present in a separate layer provided on top of the coating. In the latter embodiment, the water-repellent polymer forms a barrier layer which shields the coating from the developer and the solubility of the barrier layer in the developer or the penetrability of the barrier layer by the developer can be increased by exposure to heat or infrared light, as described in e.g. EP 864 420, EP 950 517 and WO99/21725.

Preferred examples of inhibitors which delay the penetration of the aqueous alkaline developer into the coating include water-repellent polymers including siloxane and/or perfluoroalkyl units. The polysiloxane may be a linear, cyclic or complex cross-linked polymer or copolymer. The term polysiloxane compound shall include any compound which contains more than one siloxane group -Si(R,R')-O-, wherein R and R' are optionally substituted alkyl or aryl groups. Preferred siloxanes are phenylalkylsiloxanes and dialkylsiloxanes. The number of siloxane groups in the polymer is at least 2, preferably at least 10, more preferably at least 20. It may be less than 100, preferably less than 60.

The water-repellent polymer may be a block-copolymer or a graft-copolymer including a polar block such as a poly- or oligo(alkylene oxide) and a hydrophobic block such as a long chain hydrocarbon group, a polysiloxane and/or a perfluorinated hydrocarbon group. A typical example of a perfluorinated surfactant is Megafac F-177 available from Dainippon Ink & Chemicals, Inc.. Other suitable copolymers comprise about 15 to 25 siloxane units and 50 to 70 alkyleneoxide groups. Preferred examples include copolymers comprising phenylmethylsiloxane and/or dimethylsiloxane as well as ethylene oxide and/or propylene oxide, such as Tego Glide 410, Tego Wet 265, Tego Protect 5001 or Silikophen P50/X, all commercially available from Tego Chemie, Essen, Germany.

A suitable amount of such a water-repellent polymer in the coating is between 0.5 and 25 mg/m², preferably between 0.5 and 15 mg/m² and most preferably between 0.5 and 10 mg/m². When the water-repellent polymer is also ink-repelling, e.g. in the case of polysiloxanes, higher amounts than 25 mg/m² can result in poor ink-acceptance of the non-exposed areas. An amount lower than 0.5 mg/m² on the other hand may lead to an unsatisfactory development resistance.

It is believed that during coating and drying, the water-repellent polymer or copolymer acts as a surfactant and tends to position itself, due to its bifunctional structure, at the interface between the coating and air and thereby forms a separate top layer, even when applied as an ingredient of the coating solution. Simultaneously, such surfactants also act as spreading agents which improve the coating quality. Alternatively, the water-repellent polymer or copolymer can be applied in a separate solution, coated on top of the coating including one or optional more layers. In that embodiment, it may be advantageous to use a solvent in the separate solution that is not capable of dissolving the ingredients present in the other layers so that a highly concentrated water-repellent phase is obtained at the top of the coating.

Optionally, the coating of the heat-sensitive printing plate precursor may contain a further infrared light absorbing dye or pigment which, in the embodiment where the coating comprises more than one layer, may be present in the first layer, and/or in the second layer, and/or in an optional other layer. Preferred IR absorbing dyes are cyanine dyes, merocyanine dyes, indoaniline dyes, oxonol dyes, pyrilium dyes and squarilium dyes. Examples of suitable IR dyes are described in e.g. EP-As 823327, 978376, 1029667, 1053868, 1093934; WO 97/39894 and 00/29214. A preferred compound is the following cyanine dye: 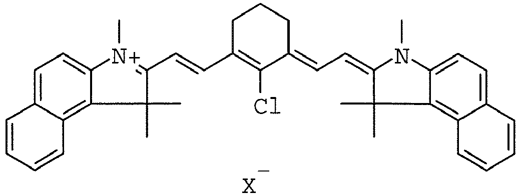 wherein X is a suitable counterion such as tosylate.

The concentration of the optional further IR-dye in the coating is preferably between 0.25 and 15.0 %wt, more preferably between 0.5 and 10.0 %wt, most preferably between 1.0 and 7.5 %wt relative to the coating as a whole.

The coating may further comprise one or more colorant(s) such as dyes or pigments which provide a visible color to the coating and which remain in the coating at the image areas which are not substantially removed during the processing step. As a result, a visible image is formed which enables inspection of the lithographic image on the developed printing plate. Such dyes are often called contrast dyes or indicator dyes. Preferably, the dye has a blue color and an absorption maximum in the wavelength range between 600 nm and 750 nm. Typical examples of such contrast dyes are the amino-substituted tri- or diarylmethane dyes, e.g. crystal violet, methyl violet, victoria pure blue, flexoblau 630, basonylblau 640, auramine and malachite green. Also the dyes which are discussed in depth in EP-A 400,706 are suitable contrast dyes. Dyes such as di- or tri-arylmethane dyes, cyanine dyes, styryl dyes and merostyryl dyes, which, combined with specific additives, only slightly color the coating but which become intensively colored after exposure, as described in for example WO2006/005688 may also be used as colorants.

To protect the surface of the coating of the heat and/or light sensitive printing plate precursors, in particular from mechanical damage, a protective layer may also optionally be applied. The protective layer generally comprises at least one water-soluble binder, such as polyvinyl alcohol, polyvinylpyrrolidone, partially hydrolyzed polyvinyl acetates, gelatin, carbohydrates or hydroxyethylcellulose, and can be produced in any known manner such as from an aqueous solution or dispersion which may, if required, contain small amounts - i.e. less than 5% by weight based on the total weight of the coating solvents for the protective layer - of organic solvents. The thickness of the protective layer can suitably be any amount, advantageously up to 5.0 µm, preferably from 0.1 to 3.0 µm, particularly preferably from 0.15 to 1.0 µm.

Optionally, the coating may further contain additional ingredients such as surfactants, especially perfluoro surfactants, inoragnic fillers or polymers particles such as matting agents and spacers. Examples of inorganic fillers include silicon or titanium dioxide particles, zirconium oxide, kaolin clays and derivatives, silicium oxide based particles optionally coated and/or modified, alumina oxide, fumed silica and cerium oxide. The particles can be in the micrometer range, typically between 1 µm and 10 *µ*m. More preferable, the particles are in the nanometer-range i.e. between 10 nm and 900 nm.

Any coating method can be used for applying one or more coating solutions to the hydrophilic surface of the support. The multi-layer coating can be applied by coating/drying each layer consecutively or by the simultaneous coating of several coating solutions at once. In the drying step, the volatile solvents are removed from the coating until the coating is self-supporting and dry to the touch. However it is not necessary (and may not even be possible) to remove all the solvent in the drying step. Indeed the residual solvent content may be regarded as an additional composition variable by means of which the composition may be optimized. Drying is typically carried out by blowing hot air onto the coating, typically at a temperature of at least 70°C, suitably 80-15O°C and especially 90-140°C. Also infrared lamps can be used. The drying time may typically be 15-600 seconds.

Between coating and drying, or after the drying step, a heat treatment and subsequent cooling may provide additional benefits, as described in WO99/21715, EP-A 1074386, EP-A 1074889, WO00/29214, and WO/04030923, WO/04030924, WO/04030925.

The lithographic printing plate precursor used in the present invention comprises a support which has a hydrophilic surface or which is provided with a hydrophilic layer. The support may be a sheet-like material such as a plate or it may be a cylindrical element such as a sleeve which can be slid around a print cylinder of a printing press. Preferably, the support is a metal support such as aluminum or stainless steel. The support can also be a laminate comprising an aluminum foil and a plastic layer, e.g. polyester film.

A particularly preferred lithographic support is a grained and anodized aluminum support. The aluminum support has usually a thickness of about 0.1-0.6 mm. However, this thickness can be changed appropriately depending on the size of the printing plate used and/or the size of the plate-setters on which the printing plate precursors are exposed. The aluminum is preferably grained by electrochemical graining, and anodized by means of anodizing techniques employing phosphoric acid or a sulphuric acid/phosphoric acid mixture. Methods of both graining and anodization of aluminum are well known in the art.

By graining (or roughening) the aluminum support, both the adhesion of the printing image and the wetting characteristics of the non-image areas are improved. By varying the type and/or concentration of the electrolyte and the applied voltage in the graining step, different type of grains can be obtained. The surface roughness is often expressed as arithmetical mean centerline roughness Ra (ISO 4287/1 or DIN 4762) and may vary between 0.05 and 1.5 µm.The aluminum substrate of the current invention has preferably an Ra value between 0.30 µm and 0.60 µm, more preferably between 0.35 µm and 0.55 µm and most preferably between 0.40 µmand 0.50 µm.The lower limit of the Ra value is preferably about 0.1 µm. More details concerning the preferred Ra values of the surface of the grained and anodized aluminum support are described in EP 1 356 926.

By anodising the aluminum support, its abrasion resistance and hydrophilic nature are improved. The microstructure as well as the thickness of the Al₂O₃ layer are determined by the anodising step, the anodic weight (g/m² Al₂O₃ formed on the aluminum surface) varies between 1 and 8 g/m². The anodic weight is preferably between 1.5 g/m² and 5.0 g/m², more preferably 2.5 g/m² and 4.0 g/m² and most preferably 2.5 g/m² and 3.5 g/m².

The grained and anodized aluminum support may be subject to a so-called post-anodic treatment to improve the hydrophilic character of its surface. For example, the aluminum support may be silicated by treating its surface with a solution including one or more alkali metal silicate compound(s) - such as for example a solution including an alkali metal phosphosilicate, orthosilicate, metasilicate, hydrosilicate, polysilicate or pyrosilicate - at elevated temperature, e.g. 95°C. Silicated supports are preferred in the embodiment were the printing plate precursors of the present invention are developed with a silicate-free developer solution. Alternatively, a phosphate treatment may be applied which involves treating the aluminum oxide surface with a phosphate solution that may further contain an inorganic fluoride. Further, the aluminum oxide surface may be rinsed with a citric acid or citrate solution, gluconic acid, or tartaric acid. This treatment may be carried out at room temperature or may be carried out at a slightly elevated temperature of about 30 to 50°C. A further interesting treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulphonic acid, polyvinylbenzenesulphonic acid, sulphuric acid esters of polyvinyl alcohol, acetals of polyvinyl alcohols formed by reaction with a sulphonated aliphatic aldehyde, polyacrylic acid or derivates such as GLASCOL E15™ commercially available from Ciba Speciality Chemicals. One or more of these post treatments may be carried out alone or in combination. More detailed descriptions of these treatments are given in GB-A 1 084 070, DE-A 4 423 140, DE-A 4 417 907, EP-A 659 909, EP-A 537 633, DE-A 4 001 466, EP-A 292 801, EP-A 291 760 and US 4,458,005.

In a preferred embodiment, the support is first treated with an aqueous solution including one or more silicate compound(s) as descibed above followed by the treatment of the support with an aqueous solution including a compound having a carboxylic acid group and/or a phosphonic acid group, or their salts. Particularly preferred silicate compounds are sodium or potassium orthosilicate and sodium or potassium metasilicate. Suitable examples of a compound with a carboxylic acid group and/or a phosphonic acid group and/or an ester or a salt thereof are polymers such as polyvinylphosphonic acid, polyvinylmethylphosphonic acid, phosphoric acid esters of polyvinyl alcohol, polyacrylic acid, polymethacrylic acid and a copolymer of acrylic acid and vinylphosphonic acid. A solution comprising polyvinylphosphonic acid or poly(meth)acrylic acid is highly preferred.

The support can also be a flexible support, which may be provided with a hydrophilic layer, hereinafter called 'base layer'. The flexible support is e.g. paper, plastic film or aluminum. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 *µ*m and is preferably 1 to 10 *µ*m. More details of preferred embodiments of the base layer can be found in e.g. EP 1 025 992.

According to the present invention there is also provided a method for making a positive-working lithographic printing plate comprising the steps of imagewise exposing the printing plate precursor followed by developing the imagewise exposed precursor so that the exposed areas are dissolved in the developer solution.

The heat-sensitive plate precursor can be image-wise exposed directly with heat, e.g. by means of a thermal head, or indirectly by infrared light, preferably near infrared light. The infrared light is preferably converted into heat by an IR light absorbing compound as discussed above. The heat-sensitive lithographic printing plate precursor is preferably not sensitive to visible light, i.e. no substantial effect on the dissolution rate of the coating in the developer is induced by exposure to visible light. Most preferably, the coating is not sensitive to ambient daylight, i.e. the wavelength range including near UV light (300-400 nm) and visible light (400-750 nm) .

The printing plate precursor can be exposed to infrared light by means of e.g. LEDs or a laser. Most preferably, the light used for the exposure is a laser emitting near infrared light having a wavelength in the range from about 750 to about 1500 nm, more preferably 750 to 1100 nm, such as a semiconductor laser diode, a Nd:YAG or a Nd:YLF laser. The required laser power depends on the sensitivity of the plate precursor, the pixel dwell time of the laser beam, which is determined by the spot diameter (typical value of modern plate-setters at 1/e² of maximum intensity: 5-25 *µ*m) , the scan speed and the resolution of the exposure apparatus (i.e. the number of addressable pixels per unit of linear distance, often expressed in dots per inch or dpi; typical value : 1000-4000 dpi) .

Two types of laser-exposure apparatuses are commonly used: internal (ITD) and external drum (XTD) platesetters. ITD platesetters for thermal plates are typically characterized by a very high scan speed up to 500 m/sec and may require a laser power of several Watts. XTD platesetters for thermal plates having a typical laser power from about 200 mW to about 1 W operate at a lower scan speed, e.g. from 0.1 to 10 m/sec. An XTD platesetter equipped with one or more laserdiodes emitting in the wavelength range between 750 and 850 nm is an especially preferred embodiment for the method of the present invention.

The known platesetters can be used as an off-press exposure apparatus, which offers the benefit of reduced press downtime. XTD platesetter configurations can also be used for on-press exposure, offering the benefit of immediate registration in a multi-color press. More technical details of on-press exposure apparatuses are described in e.g. US 5,174,205 and US 5,163,368.

After exposure, the precursor is developed whereby the non-image areas of the coating are removed by immersion in a developer, preferably an aqueous alkaline developer, which may be combined with mechanical rubbing, e.g. by a rotating brush. The developer preferably comprises an alkaline agent which may be an inorganic alkaline agent such as an alkali metal hydroxide, an organic alkaline agent such as an amine, and/or an alkaline silicate such as an alkali metal silicate or an alkali metal metasilicate. Silicate-based developers which have a ratio of silicon dioxide to alkali metal oxide of at least 1 are advantageous because they ensure that the alumina layer (if present) of the substrate is not damaged. Preferred alkali metal oxides include Na₂0 and K₂0, and mixtures thereof. A particularly preferred silicate-based developer solution is a developer solution comprising sodium or potassium metasilicate, i.e. a silicate where the ratio of silicon dioxide to alkali metal oxide is 1. The developer preferably has a pH above 8, more preferably above 10 and most preferably above 12. The developer may further contain components such as a buffer substance, a complexing agent, an antifoaming agent, an organic solvent, a corrosion inhibitor, a dye, an antisludge agent, a dissolution preventing agent such as a non-ionic surfactant, an anionic, cationic or amphoteric surfactant and/or a hydrotropic agent as known in the art. The developer may further contain a poly- hydroxyl compound such as e.g. sorbitol, preferably in a concentration of at least 40 g/1, and also a polyethylene oxide containing compound such as e.g. Supronic B25, commercially available from RHODIA, preferably in a concentration of at most 0.15 g/1.; this may be combined with mechanical rubbing, e.g. by using a rotating brush. During development, any water-soluble protective layer present is also removed. In a preferred embodiment, the developer is substantially free of silicates e.g. alkali metal silicates or alkali metal metasilicates.

More details concerning the development step can be found in for example EP 2 263 874, US 2010/0047723 and WO/2004071767.

The development step may be followed by a rinsing step and/or a gumming step. The gumming step involves post-treatment of the lithographic printing plate with a gum solution. A gum solution is typically an aqueous liquid which comprises one or more surface protective compounds that are capable of protecting the lithographic image of a printing plate against contamination or damaging. Suitable examples of such compounds are film-forming hydrophilic polymers or surfactants. A suitable gum solution which can be used after the development step is described in for example EP 1 342 568 and WO 2005/111727. The plate precursor can, if required, be further post-treated with a suitable correcting agent or preservative as known in the art.

To increase the resistance of the finished printing plate and hence to extend its press life capability the layer can be briefly heated to elevated temperatures ("baking"). The plate can be dried before baking or is dried during the baking process itself. During the baking step, the plate can be heated at a temperature which is higher than the glass transition temperature of the heat-sensitive coating, e.g. between 100°C and 230°C for a period of 40 seconds to 5 minutes. Baking can be done in conventional hot air ovens or by exposure to lamps emitting in the infrared or ultraviolet spectrum. As a result of this baking step, the resistance of the printing plate to plate cleaners, correction agents and UV curable printing inks increases. Such a thermal post-treatment is described, inter alia, in DE 1,447,963 and GB 1,154,749.

The heat and/or light sensitive printing plates can be used for conventional, so-called wet offset printing, in which ink and an aqueous dampening liquid are supplied to the plate. Another suitable printing method uses so-called single-fluid ink without a dampening liquid. Suitable single-fluid inks have been described in US 4,045,232; US 4,981,517 and US 6,140,392. In a most preferred embodiment, the single-fluid ink comprises an ink phase, also called the hydrophobic or oleophilic phase, and a polyol phase as described in WO 00/32705.

### EXAMPLES

### 1. IR-dyes.

The IR-dyes IR-1 to IR-04, IR-07 to IR-10, and IR-12 according to the present invention, reference dyes IR-05, IR-06, IR-11, and comparative IR-dye (Comp-01) are given in the Table 1 below.

**Table 1: IR-dyes.**

| | |
|---|---|
| 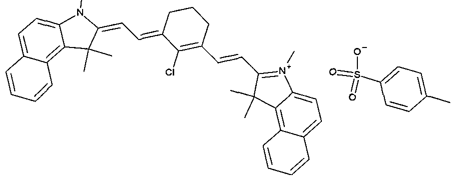 | Comp-01 |
| 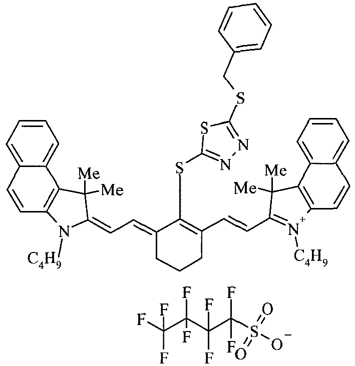 | IR-01 |
| 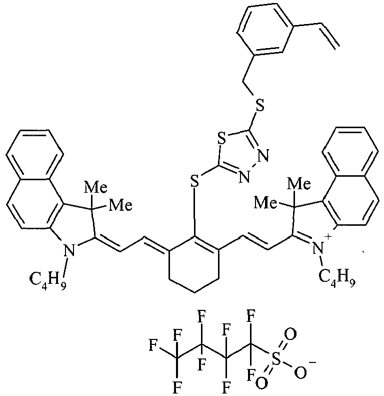 | IR-02 |
| 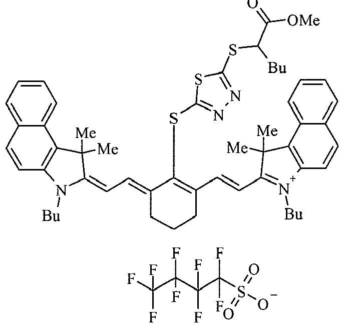 | IR-03 |
| 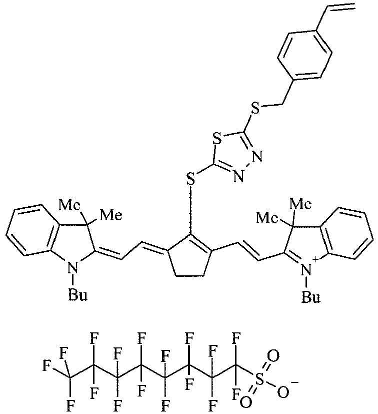 | IR-04 |
| 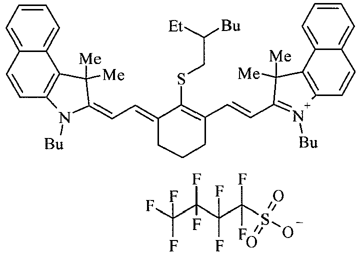 | IR-05 (reference) |
| 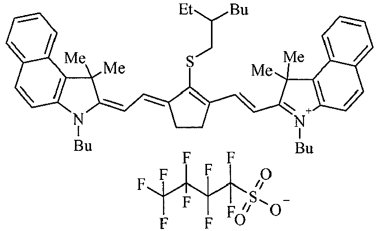 | IR-06 (reference) |
| 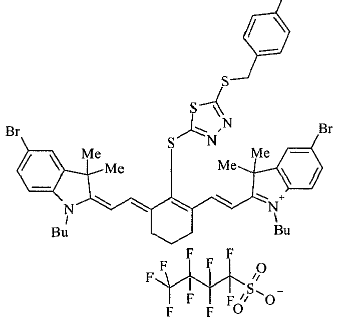 | IR-07 |
| 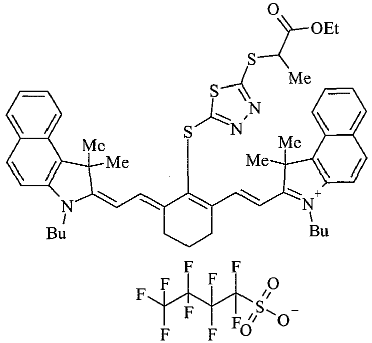 | IR-08 |
| 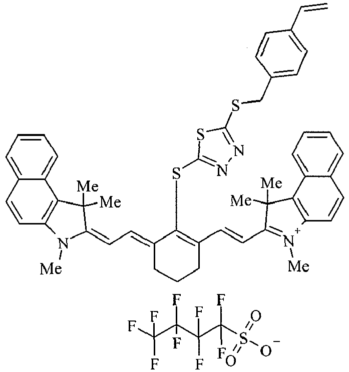 | IR-09 |
| 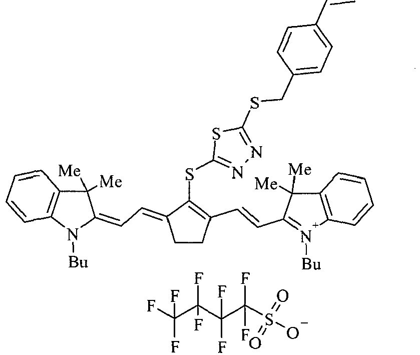 | IR-10 |
| 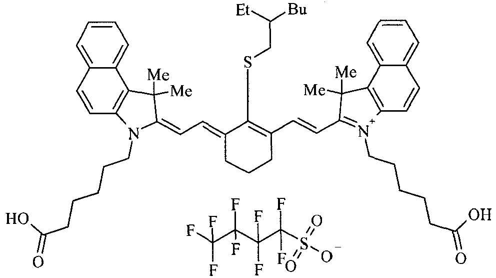 | IR-11 (reference) |
| 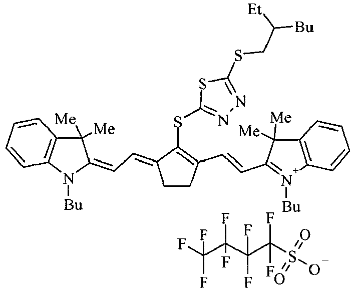 | IR-12 |

### 2. Synthesis of the infrared dyes according to the present invention.

### 2.1 Synthesis of the intermediate mercapto-thiadiazole derivatives.

### Synthesis of 2-(5-mercapto-[1,3,4]thiadiazol-2-ylsulfanyl)-propionic acid ethyl ester:

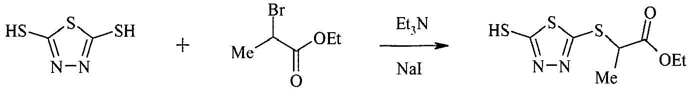

15 g (0.1 mol) 2,5-dimercapto-[1,3,4]-thiadiazole was dissolved in 70 ml acetone. 10.1 g (0.1 mol) triethyl amine and 0.5 g sodium iodide were added. 15 g (0.083 mol) 2-bromo-propionic acid ethyl ester was added and the mixture was stirred for one hour at 25°C. 500 ml water was added. The separated organic layer was isolated. 200 ml methylene chloride was added and the solution was extracted once with 200 ml water and once with 200 ml of a 1M NaHCO₃ solution. The organic layer was isolated, dried over MgSO₄ and evaporated under reduced pressure. 12 g (y : 57%) of 2-(5-mercapto-[1,3,4]thiadiazol-2-ylsulfanyl)-propionic acid ethyl ester was isolated as an oily compound (TLC analysis on Partisil KC18F supplied by Whatman using MeOH/0.5 M NaCl as eluent : R_{f} = 0.53).
The obtained 2-(5-mercapto-[1,3,4]thiadiazol-2-ylsulfanyl)-propionic acid ethyl ester was used without further purification.

### Synthesis of 2-(5-mercapto-[1,3,4]thiadiazol-2-ylsulfanyl)-hexanoic acid methyl ester:

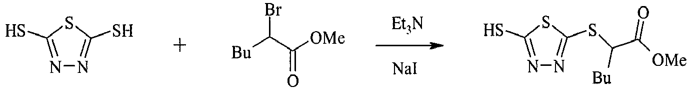

15 g (0.1 mol) 2,5-dimercapto-[1,3,4]-thiadiazole was dissolved in 70 ml acetone. 10.1 g (0.1 mol) triethyl amine and 0.5 g sodium iodide were added. 17.5 g (0.083 mol) 2-bromo-hexanoic acid methyl ester was added and the mixture was stirred for one hour at 25°C. 500 ml water was added. The separated organic layer was isolated. 200 ml methylene chloride was added and the solution was extracted once with 200 ml water and once with 200ml of a 1M NaHCO₃ solution. The organic layer was isolated, dried over MgSO₄ and evaporated under reduced pressure. 18 g (y : 78%) of 2-(5-mercapto-[1,3,4]thiadiazol-2-ylsulfanyl)-hexanoic acid methyl ester was isolated as an oily compound (TLC analysis on Partisil KC18F supplied by Whatman using MeOH/0.5 M NaCl as eluent : R_{f} = 0.37).

The obtained 2-(5-mercapto-[1,3,4]thiadiazol-2-ylsulfanyl)-hexanoic acid methyl ester was used without further purification.

### Synthesis of 5-benzylsulfanyl-[1,3,4]-thiadiazole-2-thiol:

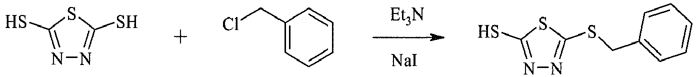

15 g (0.1 mol) 2,5-dimercapto-[1,3,4]-thiadiazole was dissolved in 70 ml methanol. 10.1 g (0.1 mol) triethyl amine and 0.5 g sodium iodide were added. 10.5 g (0.083 mol) benzylchloride was added and the mixture was stirred for two hour at 25°C. 70 ml water was added slowly and the crude 5-benzylsulfanyl-[1,3,4]-thiadiazole-2-thiol precipitated from the medium. The crude 5-benzylsulfanyl-[1,3,4]-thiadiazole-2-thiol was isolated by filtration and recrystallized from 70 ml methanol. The recrystallized 5-benzylsulfanyl-[1,3,4]-thiadiazole-2-thiol was isolated by filtration, washed with a small amount of methanol and dried. 7.8 g (y : 39%) of 5-benzylsulfanyl-[1,3,4]-thiadiazole-2-thiol was isolated (TLC analysis on TLC Silica gel 60F₂₅₄ supplied by Merck using methylene chloride as eluent : R_{f} = 0.68 (tailing)).

### Synthesis 5-(4-vinyl-benzylsulfanyl)-[1,3,4]-thiadiazole-2-thiol:

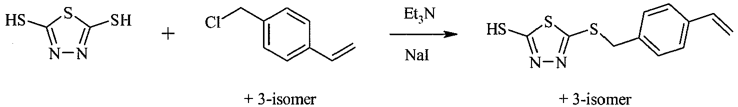

15 g (0.1 mol) 2,5-dimercapto-[1,3,4]-thiadiazole was dissolved in 100 ml methanol. 10.1 g (0.1 mol) triethyl amine was added. 12.6 g (0.083 mol) of a mixture of (4-chloromethyl)styrene and (3-chloro methyl)styrene was added and the mixture was stirred for two hour at 20°C. The crude 5-(4-vinyl-benzylsulfanyl)-[1,3,4]-thiadiazole-2-thiol precipitated from the medium. A small amount of methanol was added to dilute the slurry. The crude 5-(4-vinyl-benzylsulfanyl)-[1,3,4]-thiadiazole-2-thiol was isolated by filtration and dried. The crude 5-(4-vinyl-benzylsulfanyl)-[1,3,4]-thiadiazole-2-thiol was dispersed in 100 ml toluene and stirred for three hours. 5-(4-vinyl-benzylsulfanyl)-[1,3,4]-thiadiazole-2-thiol was isolated by filtration, washed with a small amount of toluene and hexane and dried. 11 g (y : 50%) of 5-(4-vinyl-benzylsulfanyl)-[1,3,4]-thiadiazole-2-thiol was isolated isolated (TLC analysis on TLC Silica gel 60F₂₅₄ supplied by Merck using methylene chloride/ ethyl acetate 97/3 as eluent : R_{f} = 0.3).

### Synthesis of 5-(2-ethyl-hexylsulfanyl)-[1,3,4]-thiadiazole-2-thiol:

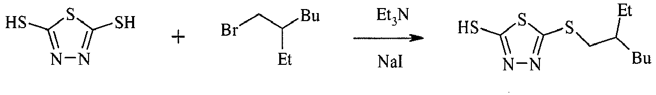

5.4 g (36 mmol) 2,5-dimercapto-[1,3,4]-thiadiazole was dissolved in 50 ml acetone. 3.6 g (36 mmol) triethyl amine and 0.3 g sodium iodide were added. 5.8 g (30 mmol) 2-ethyl-hexyl bromide was added and the reaction was allowed to continue for two hours at 40°C. 40 ml water was added to the mixture and 5-(2-ethyl-hexylsulfanyl)-[1,3,4]-thiadiazole-2-thiol precipitated from the mixture. The crude 5-(2-ethyl-hexylsulfanyl)-[1,3,4]-thiadiazole-2-thiol was isolated by filtration and dried. The isolated 5-(2-ethyl-hexylsulfanyl)-[1,3,4]-thiadiazole-2-thiol was dispersed in 50 ml toluene and stirred for three hours. 5-(2-ethyl-hexylsulfanyl)-[1,3,4]-thiadiazole-2-thiol was isolated by filtration, washed with a small amount of toluene and hexane and dried. 2 g (y : 25 %) of 5-(2-ethyl-hexylsulfanyl)-[1,3,4]-thiadiazole-2-thiol was isolated (TLC analysis on TLC Silica gel 60F₂₅₄ supplied by Merck using methylene chloride as eluent : R_{f} = 0.7).

### 2.2 Synthesis of the intermediate meso-chloro-cyanine dyes.

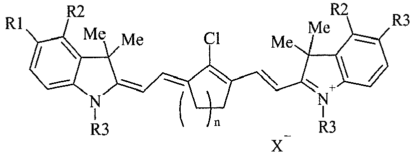

The intermediate meso-chloro-cyanine dyes can be prepared as disclosed in WO2013/055640 (Eastman Kodak Company) and by Nagao et al. (Dyes and Pigments, 73(3), 344-352 (2006)), Xing et al. (Macromolecular Chemistry and Physics, 214(5), 578-588 (2013)) and Mojzych et al. (Heterocyclic Communications, 15(2), 123-126 (2009)).

### 2.3 The synthesis of the infrared dyes according to the present invention.

### Inventive infrared dye IR-01:

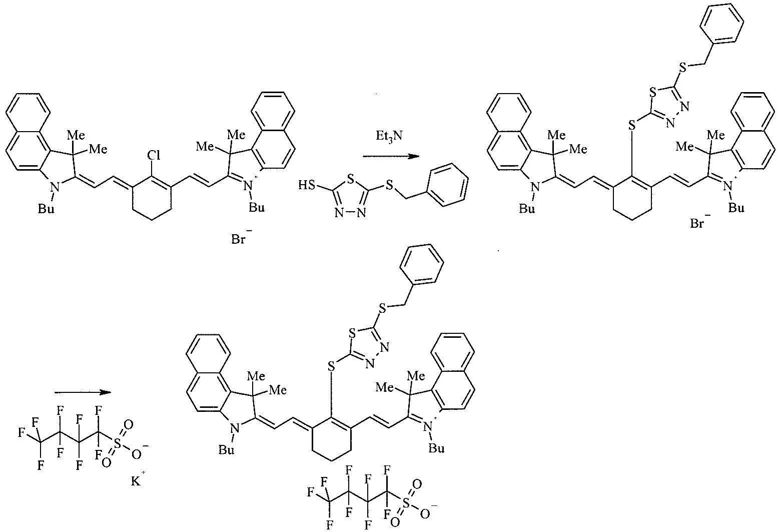

7.5 g (10 mmol) of the starting IR dye and 2.8 g (11.5 mmol) of 5-benzylsulfanyl-[1,3,4]-thiadiazole-2-thiol were dissolved in a mixture of 30 ml methylene chloride and 20 ml methanol. 1.15 g (11.5 mmol) triethyl amine was added and the reaction was allowed to continue at room temperature for 16 hours. 500 ml water was added and the organic layer was isolated. An additional 100 ml methylene chloride was added followed by the addition of a solution of 5 g (14.7 mmol) of nonafluoro-butane-1-sulfonic acid potassium salt in 100 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-1 precipitated as an oil, was isolated and dried. 10 g of the inventive infrared dye IR-1 was isolated (y : 85%, UV-VIS λₘₐₓ: 841 nm in methanol).

### Inventive infrared dye IR-02:

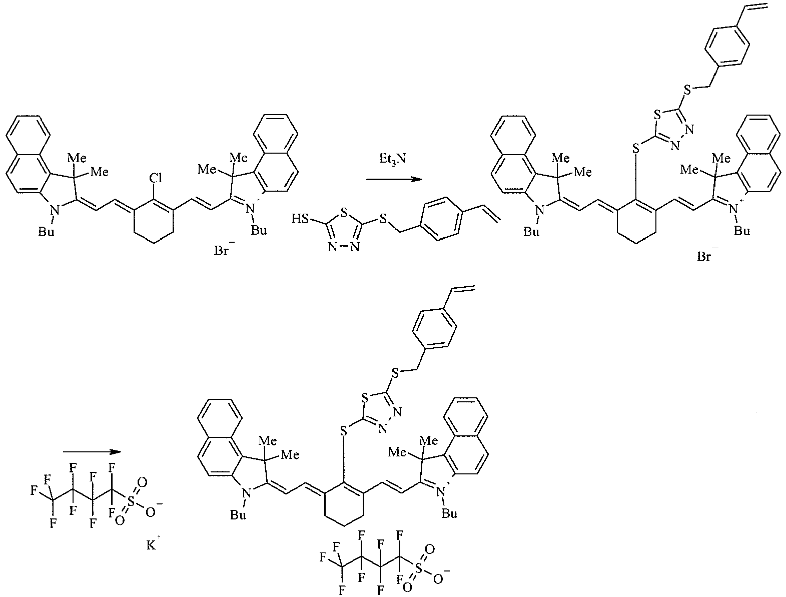

7.5 g (10 mmol) of the starting IR dye and 3.06 g (11.5 mmol) of 5-(4-vinyl-benzylsulfanyl)-[1,3,4]-thiadiazole-2-thiol were dissolved in a mixture of 30 ml methylene chloride and 20 ml methanol. 1.15 g (11.5 mmol) triethyl amine was added and the reaction was allowed to continue at room temperature for 16 hours. 500 ml water was added and the organic layer was isolated. An additional 100 ml methylene chloride was added followed by the addition of a solution of 5 g (14.7 mmol) of nonafluoro-butane-i-sulfonic acid potassium salt in 100 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-2 precipitated as an oil, was isolated and dried. 9.2 g of the inventive infrared dye IR-2 was isolated (y : 76%, UV-VIS λₘₐₓ: 842 nm in methanol).

### Inventive infrared dye IR-03:

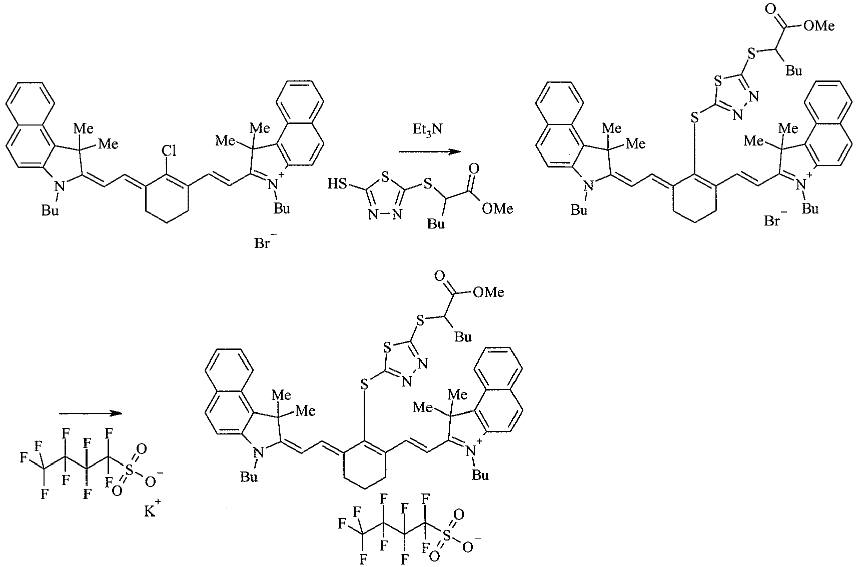

7.5 g (10 mmol) of the starting IR dye and 3.2 g (11.5 mmol) of 2-(5-mercapto-[1,3,4]thiadiazol-2-ylsulfanyl)-hexanoic acid methyl ester were dissolved in a mixture of 30 ml methylene chloride and 20 ml methanol. 1.15 g (11.5 mmol) triethyl amine was added and the reaction was allowed to continue at room temperature for 16 hours. An additional 0.32 g (1.15 mmol) 2-(5-mercapto-[1,3,4]thiadiazol-2-ylsulfanyl)-hexanoic acid methyl ester and 0.115 g (1.15 mmol) triethyl amine were added and the reaction was allowed to continue for four hours at room temperature. 500 ml of a 0.1 M NaHCO₃ solution was added and the organic layer was isolated. An additional 50 ml methylene chloride was added followed by the addition of a solution of 5 g (14.7 mmol) of nonafluoro-butane-1-sulfonic acid potassium salt in 150 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-3 precipitated as an oil, was isolated and dried. 9 g of the inventive infrared dye IR-3 was isolated (y : 74%, UV-VIS λₘₐₓ: 840 nm in methanol).

### Inventive infrared dye IR-04:

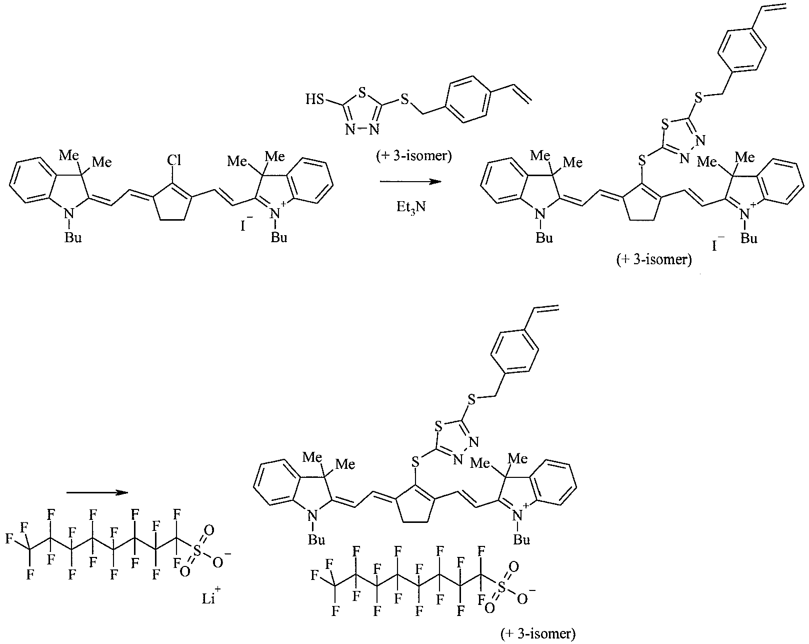

20.4 g (0.03 mol) of the starting infrared dye and 8.8 g (0.033 mol) 5-(4-vinyl-benzylsulfanyl)-[1,3,4]-thiadiazole-2-thiol were dissolved in 75 ml methylene chloride. 3.3 g (0.033 mol) triethyl amine was added and the reaction was allowed to continue for 30 minutes. 2.1 g (0.0078 mol) of 5-(4-vinyl-benzylsulfanyl)-[1,3,4]-thiadiazole-2-thiol was added in three portions, each time followed by allowing the reaction to continue for 30 minutes. 200 ml water was added and the organic layer was isolated. The solvent was removed under reduced pressure and the intermediate iodide was isolated as an oily compound. The intermediate was converted to inventive infrared dye IR-4 without further purification.

25 g of the crude intermediate iodide was dissolved in 400 ml methyl-t.butyl-ether. 151 g of a 30w% solution (0.09 mol) of heptadecafluoro-1-octane-sulfonic acid lithium salt, diluted with 300 ml water was added and the mixture was stirred for 30 minutes.

The organic fraction was isolated and extracted once with 500 ml water and once with 200 ml of a 5 w% sodium chloride solution. The solvent was evaporated under reduced pressure and the oily residue was dissolved in 200 ml methylene chloride. The solution was dried over MgSO₄. The solvent was evaporated under reduced pressure and inventive infrared dye IR-4 was isolated as an oily compound. 23 g of inventive infrared dye IR-4 was isolated (y : 70%, UV-VIS λₘₐₓ : 843 nm in methanol).

### Infrared dye IR-05:

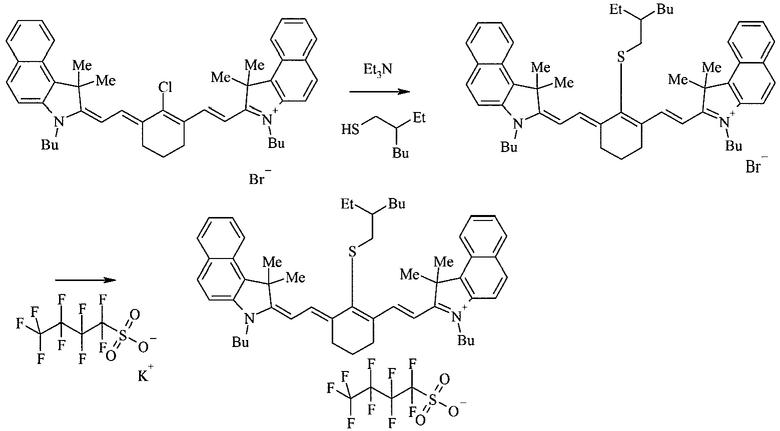

7.5 g (10 mmol) of the starting IR dye and 1.68 g (11.5 mmol) of 2-ethyl-hexylmercaptane were dissolved in a mixture of 30 ml methylene chloride and 20 ml methanol. 1.15 g (11.5 mmol) triethyl amine was added and the reaction was allowed to continue at room temperature for 16 hours. 500 ml water was added and the organic layer was isolated. An additional 100 ml methylene chloride was added followed by the addition of a solution of 5 g (14.7 mmol) of nonafluoro-butane-1-sulfonic acid potassium salt in 100 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-5 precipitated as an oil, was isolated and dried. 8 g of the inventive infrared dye IR-5 was isolated (y : 74%, UV-VIS λₘₐₓ : 821 nm in methanol) .

### Infrared dye IR-06:

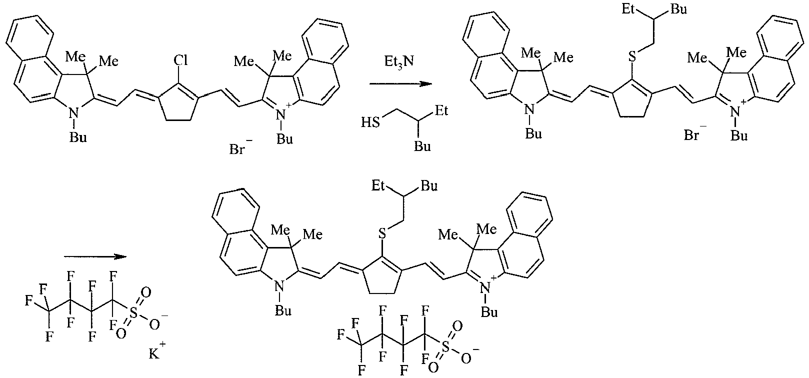

7.4 g (10 mmol) of the starting IR dye and 1.68 g (11.5 mmol) of 2-ethyl-hexylmercaptane were dissolved in a mixture of 30 ml methylene chloride and 20 ml methanol. 1.15 g (11.5 mmol) triethyl amine was added and the reaction was allowed to continue at room temperature for 2 hours. 500 ml water was added and the organic layer was isolated. An additional 100 ml methylene chloride was added followed by the addition of a solution of 5 g (14.7 mmol) of nonafluoro-butane-1-sulfonic acid potassium salt in 100 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-6 precipitated as an oil, was isolated and dried. 6 g of the inventive infrared dye IR-6 was isolated (y : 56%, UV-VIS λₘₐₓ : 851 nm in methanol).

### Inventive infrared dye IR-07:

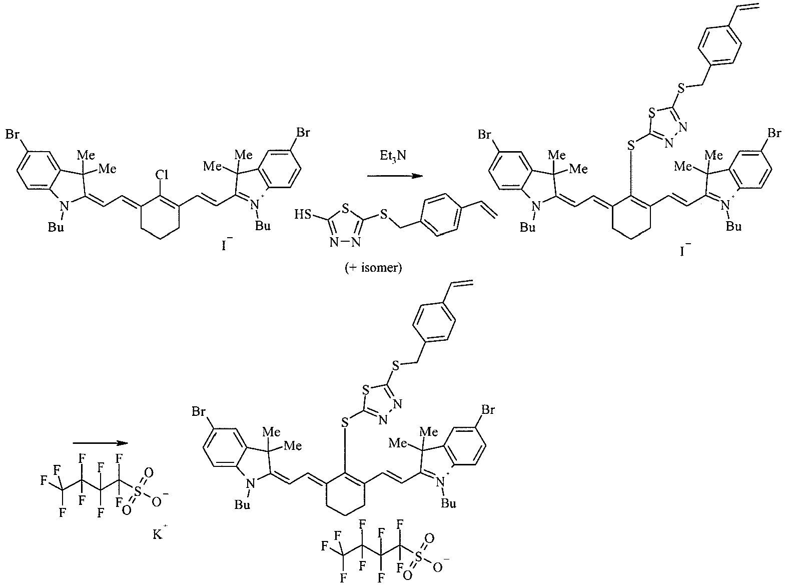

6.3 g (7.05 mmol) of the starting IR dye and 2.2 g (8.17 mmol) of 5-(4-vinyl-benzylsulfanyl)-[1,3,4]-thiadiazole-2-thiol were dissolved in a mixture of 24 ml methylene chloride and 16 ml methanol. 0.82 g (8.17 mmol) triethyl amine was added and the reaction was allowed to continue at room temperature for 16 hours. 500 ml water was added and the organic layer was isolated. An additional 100 ml methylene chloride was added followed by the addition of a solution of 3.4 g (10 mmol) of nonafluoro-butane-1-sulfonic acid potassium salt in 100 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-7 precipitated as an oil, was isolated and dried. 6 g of the inventive infrared dye IR-7 was isolated (y : 68%, UV-VIS λₘₐₓ : 812 nm in methanol) .

### Inventive infrared dye IR-08:

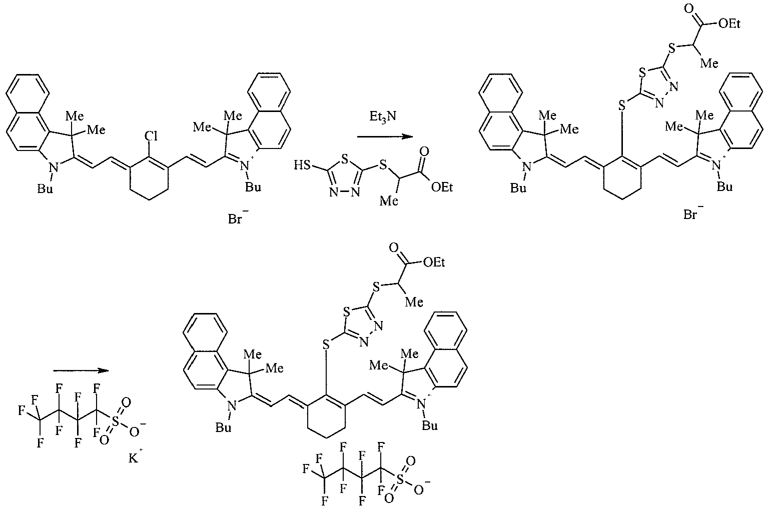

7.5 g (10 mmol) of the starting IR dye and 2.9 g 2-(5-mercapto-[1,3,4]thiadiazol-2-ylsulfanyl)-propionic acid ethyl ester (11.5 mmol) of were dissolved in a mixture of 30 ml methylene chloride and 20 ml methanol. 1.15 g (11.5 mmol) triethyl amine was added and the reaction was allowed to continue at room temperature for 16 hours. An additional gram (4 mmol) of 2-(5-mercapto-[1,3,4]thiadiazol-2-ylsulfanyl)-propionic acid ethyl ester and 0.4 g (4 mmol) of triethyl amine were added. The reaction was allowed to continue for an additional six hours at room temperature. 500 ml water was added and the organic layer was isolated. An additional 100 ml methylene chloride was added followed by the addition of a solution of 5 g (14.7 mmol) of nonafluoro-butane-1-sulfonic acid potassium salt in 50 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-8 precipitated as an oil, was isolated and dried. 8 g of the inventive infrared dye IR-8 was isolated (y : 67%, UV-VIS λₘₐₓ : 840 nm in methanol).

### Inventive infrared dye IR-09:

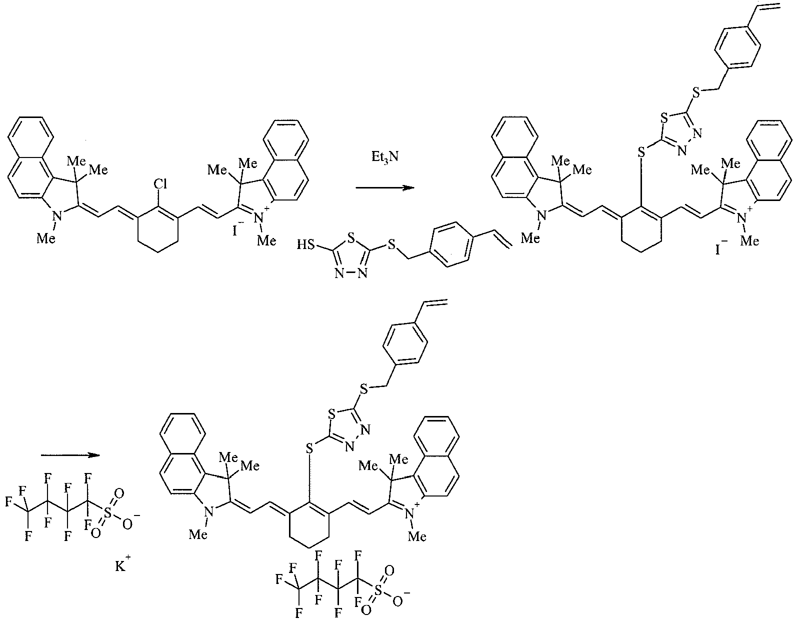

7.1 g (10 mmol) of the starting IR dye and 3.06 g (11.5 mmol) of 5-(4-vinyl-benzylsulfanyl)-[1,3,4]-thiadiazole-2-thiol were dissolved in a mixture of 30 ml methylene chloride and 20 ml methanol. 1.15 g (11.5 mmol) triethyl amine was added and the reaction was allowed to continue at room temperature for 16 hours. 500 ml water was added and the organic layer was isolated. An additional 100 ml methylene chloride was added followed by the addition of a solution of 5 g (14.7 mmol) of nonafluoro-butane-1-sulfonic acid potassium salt in 150 ml water. The mixture was stirred for 30 minutes at room temperature. The organic layer was isolated, washed with 100 ml of a 0.1 M NaHCO₃ solution and dried over MgSO₄. The solvent was removed and 100 ml methyl-t.butyl-ether was added followed by the addition of 150 ml hexane. Inventive infrared dye IR-9 precipitated as an oil, was isolated and dried. 10.5 g of the inventive infrared dye IR-9 was isolated (y : 94 %, UV-VIS λₘₐₓ: 835 nm in methanol) .

### Inventive infrared dye IR-10:

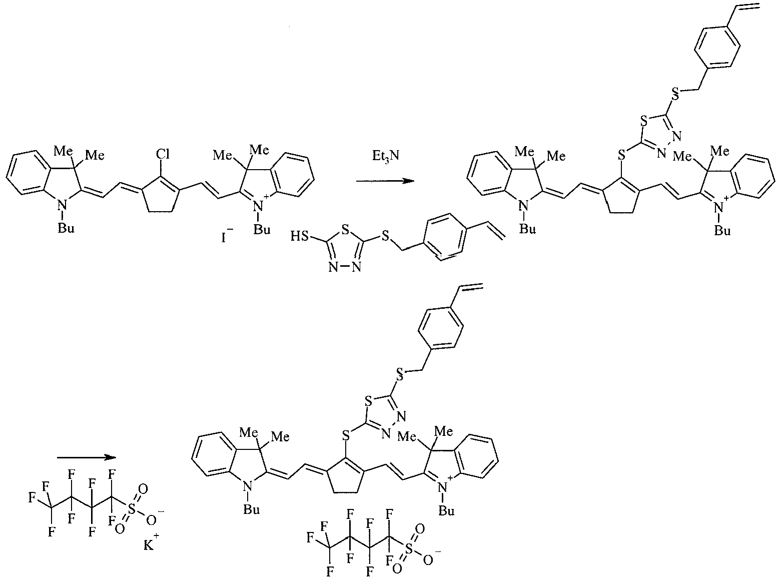

6.81 g (10 mmol) of the starting IR dye and 3.06 g (11.5 mmol) of 5-(4-vinyl-benzylsulfanyl)-[1,3,4]-thiadiazole-2-thiol were dissolved in a mixture of 30 ml methylene chloride and 20 ml methanol. 1.15 g (11.5 mmol) triethyl amine was added and the reaction was allowed to continue at room temperature for one hour. 500 ml water was added and the organic layer was isolated. An additional 100 ml methylene chloride was added followed by the addition of a solution of 5 g (14.7 mmol) of nonafluoro-butane-1-sulfonic acid potassium salt in 150 ml water. The mixture was stirred for 30 minutes at room temperature. The organic layer was isolated, washed with 100 ml of a 0.1 M NaHCO₃ solution and dried over MgSO₄. The solvent was removed and 100 ml methyl-t.butyl-ether was added followed by the addition of 150 ml hexane. Inventive infrared dye IR-10 precipitated as an oil, was isolated and dried. 8.8 g of the inventive infrared dye IR-10 was isolated (y : 81 %, UV-VIS λₘₐₓ : 834 nm in methanol) .

### Infrared dye IR-11:

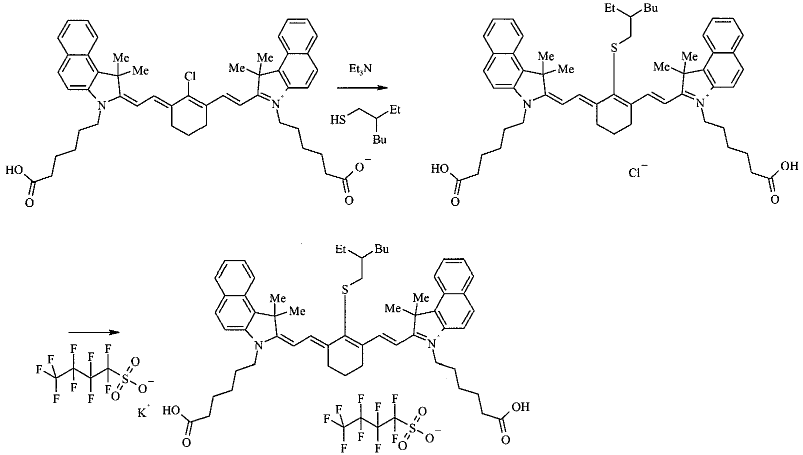

7.8 g (10 mmol) of the starting IR dye and 1.68 g (11.5 mmol) of 2-ethyl-hexylmercaptane were dissolved in a mixture of 30 ml methylene chloride and 20 ml methanol. 2.15 g (21.5 mmol) triethyl amine was added and the reaction was allowed to continue at room temperature for 16 hours. 900 ml water and 30 ml 1 N HCl were added and the organic layer was isolated. The organic layer was extracted once with 100 ml water. An additional 100 ml methylene chloride was added to the organic fraction followed by the addition of a solution of 5 g (14.7 mmol) of nonafluoro-butane-1-sulfonic acid potassium salt in 150 ml water. The mixture was stirred for 30 minutes at room temperature. The organic layer was isolated, washed with 100 ml of a 0.1 M NaHCO₃ solution and dried over MgSO₄. The solvent was removed and 100 ml methyl-t.butyl-ether was added followed by the addition of 150 ml hexane. Inventive infrared dye IR-11 precipitated as an oil, was isolated and dried. 9 g of the inventive infrared dye IR-11 was isolated (y : 75 %, UV-VIS λₘₐₓ : 823 nm in methanol) .

### Inventive infrared dye IR-12:

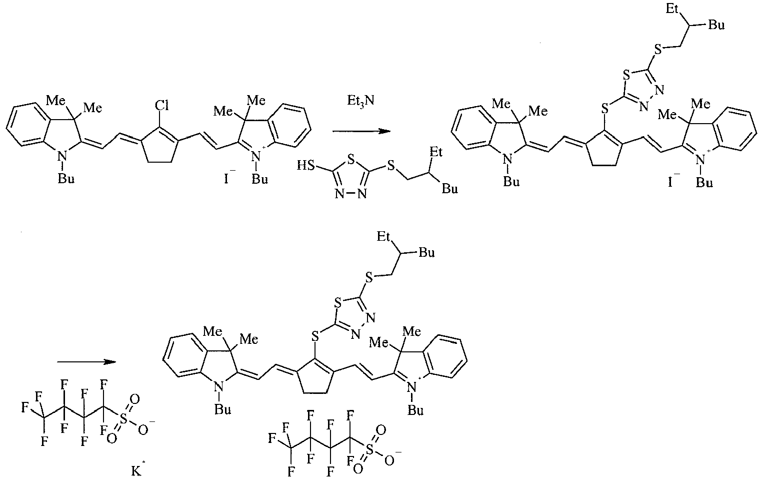

5.6 g (8.3 mmol) of the starting IR dye and 2.5 g (9.5 mmol) of 5-(2-ethyl-hexylsulfanyl)-[1,3,4]-thiadiazole-2-thiol were dissolved in a mixture of 30 ml methylene chloride and 20 ml methanol. 1 g (10 mmol) triethyl amine was added and the reaction was allowed to continue at room temperature for 30 minutes. 300 ml water was added and the organic layer was isolated. The organic layer was extracted with 300 ml of a 0.1 M NaHCO₃ solution. An additional 100 ml methylene chloride was added to the organic fraction followed by the addition of a solution of 4 g (11.8 mmol) of nonafluoro-butane-1-sulfonic acid potassium salt in 150 ml water. The mixture was stirred for 30 minutes at room temperature. The organic layer was isolated, washed with 100 ml of a 0.1 M NaHCO₃ solution and dried over MgSO₄. The solvent was removed and 150 ml methyl-t.butyl-ether was added followed by the addition of 150 ml hexane. Inventive infrared dye IR-12 precipitated as an oil, was isolated and dried. 3.3 g of the inventive infrared dye IR-12 was isolated (y : 37 %, UV-VIS λₘₐₓ : 832 nm in methanol) .

Unless otherwise specified, all compounds and solvents used in the Examples are readily available from fine chemical suppliers such as Acros or Aldrich.

The structure of the infrared dyes according to the present invention has been analyzed using LC MS, according to the following method.

The analysis was done on a HP1000 Esquire-LC, using a Machery Nagel C18 Pyramid column (125x2), packed with a 5 *µ*m C18 silica, using ESI as ionisation method. A sample of 2 mg of each dye was dissolved in 20 ml methanol. 5 *µ*l of the solution was injected and the sample was eluted using a gradient elution according to the following Table.

| Time | % B |
|---|---|
| 0 | 55 |
| 3 | 55 |
| 13 | 100 |
| 30 | stop |

Eluent A: water/methanol 9/1, containing 10 mml ammonium acetate
Eluent B: methanol, containing 10 mmol ammonium acetate

### 3. Printing plate precursors.

### 3.1 Preparation of the lithographic support S-01.

A 0.3 mm thick aluminium foil was degreased by spraying with an aqueous solution containing 34 g/l NaOH at 70°C for 6 seconds and rinsed with demineralised water for 3.6 seconds. The foil was then electrochemically grained during 8 seconds using an alternating current in an aqueous solution containing 15 g/l HCl, 15 g/l SO₄²⁻ ions and 5 g/l Al³⁺ ions at a temperature of 37°C and a current density of about 100 A/dm² (charge density of about 800 C/dm²). Afterwards, the aluminium foil was desmutted by etching with an aqueous solution containing 6.5 g/l of sodium hydroxide at 35°C for 5 seconds and rinsed with demineralised water for 4 seconds. The foil was subsequently subjected to anodic oxidation during 10 seconds in an aqueous solution containing 145 g/l of sulfuric acid at a temperature of 57°C and an anodic charge of 250 C/dm², then washed with demineralised water for 7 seconds and dried at 120°C for 7 seconds.

The support thus obtained was characterised by a surface roughness Rₐ of 0.45-0.50 µm *(*measured with interferometer NT3300 and had an anodic weight of about 3.0 g/m² (gravimetric analysis).

The lithographic support S-01 was produced by spraying onto the obtained support a post-treatment solution containing 2.2 g/l polyvinylphosphonic acid (PVPA) for 4 seconds at 70°C, rinsed with demineralised water for 3.5 seconds and dried at 120°C for 7 seconds.

### 3.2 Preparation of the printing plate precursors.

A 50 g coating solution was prepared by mixing the components as described in Table 2. The amount of IR-dye was maintained equimolar and the minimal weight differences were corrected with the Dowanol PM solvent.

Each of the coating solutions were coated onto the lithographic support S-01 by means of a semi-automated coating device in a wet-layer thickness of 26 µm. The coating was dried for 1 min at 100°C.

**Table 2: Printing plate precursors PPP-01 to PPP-09.**

| Ingredient | PPP-01 *Comp* | PPP-02 *inv* | PPP-03 *inv* | PPP-04 *Inv* | PPP-05 | PPP-06 *inv* | PPP-07 *inv* | PPP-08 *inv* | PPP-09 *inv* |
|---|---|---|---|---|---|---|---|---|---|
| Tego 265 - 1% (1) | 0,425 | = | = | = | = | = | = | = | = |
| Tego 410 - 1% (2) | 0,210 | = | = | = | = | = | = | = | = |
| Tego 100 10% (3) | 0,152 | = | = | = | = | = | = | = | = |
| MEK | 13,30 | = | = | = | = | = | = | = | = |
| Dowanol PM (4) | 14,86 | 14,79 | 14,80 | 14,81 | 14,82 | 14,81 | 14,81 | 14,79 | 14,79 |
| THF | 10,46 | = | = | = | = | = | = | = | = |
| TMCA 10% (5) | 2,67 | = | = | = | = | = | = | = | = |
| Comp 1 (6) | 0,105 | | | | | | | | |
| Inv 1 (7) | | 0,178 | | | | | | | |
| Inv 2 (7) | | | 0,166 | | | | | | |
| Inv 3 (7) | | | | 0,163 | | | | | |
| Inv 5 (7) | | | | | 0,148 | | | | |
| Inv 7 (7) | | | | | | 0,164 | | | |
| Inv 8 (7) | | | | | | | 0,155 | | |
| Inv 9 (7) | | | | | | | | 0,170 | |
| Inv 10 (7) | | | | | | | | | 0.151 |
| Basonyl Blue (8) | 2,65 | = | = | = | = | = | = | = | = |
| Alnovol SPN452 (9) | 5,16 | = | = | = | = | = | = | = | = |

| | | | | | | | | | |
|---|---|---|---|---|---|---|---|---|---|
| (1) 1 wt % solution of Tegoglide 265 in Dowanol PM (see 4 below); Tegoglide 265 is a copolymer of polysiloxane and poly(alkylene oxide), commercially available from Tego Chemie Service GmbH.; (2) 1 wt % solution of Tegoglide 410 in Dowanol PM (see 4 below); Tegoglide 410 is a copolymer of polysiloxane and poly(alkylene oxide), commercially available from Tego Chemie Service GmbH.; (3) 10 wt % solution of Tegoglide 100 in Dowanol PM (see 4 below); Tegoglide 410 is a copolymer of polysiloxane and poly(alkylene oxide), commercially available from Tego Chemie Service GmbH.; (4) Dowanol PM: propyleneglycol-monomethylether(1-methoxy-2-propanol) commercially available from Dow Chemical Company; (5) TMCA is 3,4,5-trimethoxy cinnamic acid 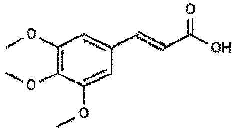 (6) Comparative IR-dye, commercially available from FEW CHEMICALS; see Table 1 above; (7) Inventive IR-dyes, see Table 1 above; (8) 1% wt Basonyl Blue 640 in 1-methoxy-2-propanol supplied by BASF; (9) Alnovol SPN452 is a 44.3 % wt. solution of novolac resin in Dowanol PM (see 4 above) commercially available from Clariant GmbH; printing plate precursor PPP-05 is included in the list for reference. | | | | | | | | | |

### 3.3 Ablation test method.

In a first step, ablation dust is collected via the Fast Filter Collection (FFC) method. Subsequently, the Total Organic Carbon (TOC) measurement provides an accurate value of weight of the released solid dust per plate surface (e.g. mg carbon/m²).

### Fast Filter Collection

Fast Filter Collection (FFC) is a gravimetric method which provides an accurate value of the total mass of ablation dust which is released upon exposure per plate surface (e.g. mg/m²).

The Fast Filter Collection (FFC) method is performed on the Creo Trendsetter, a platesetter having a 20 W infrared laser head (830 nm), operating at 140 rpm and 2400dpi, commercially available from Eastman Kodak Corp.

A filter (Pallflex™ Membrame Filter Tissu; Quartz 47 mm; rec. no. 7202) is placed between the laser head and the vacuum cleaner, directly after the laser head. The filter is blocked between a grid and a support. A surface area of the printing plate precursor of about 1050 cm² is exposed to 200 mJ/cm² and the dust is collected on 11 cm² of filter. Subsequently, the level of ablation is quantified by means of the Total Organic Carbon (TOC) measurement.

### Total Organic Carbon (TOC) measurement

TOC analysis is a quantitative method providing a total weight of all organic carbon atoms present in the sample obtained by the FFC method. The amount of carbon atoms which were released during the exposure step due to the ablation phenomenon - i.e. mg carbon/m² - is obtained and gives an idea about the degree of ablation.

More details concerning this measurement can be found in the following standards:
ISO NBN EN 15936/2012: Sludge, treated bio-waste, soil and waste - Determination of total organic carbon (TOC) by dry combustion.
NBN EN 13137/2001: Characterization of waste - Determination of total organic carbon (TOC) in waste, sludges and sediments.

The results of the ablation test performed on PPP-01 to PPP-09 are given in Table 3 below.

**Table 3: Ablation results**

| Printing plate precursor | IR-Dye | Level of ablation | Reduction of ablation |
|---|---|---|---|
| | | mg carbon/m² | % |
| PPP-01 | comp 1 | 5,20 | 0% |
| PPP-02 | IR-01 | 3,32 | 36% |
| PPP-03 | IR-02 | 3,43 | 34% |
| PPP-04 | IR-03 | 3,47 | 33% |
| PPP-05 | IR-05 | 2,76 | 47% |
| PPP-06 | IR-07 | 3,63 | 30% |
| PPP-07 | IR-08 | 4,62 | 11% |
| PPP-08 | IR-09 | 3,04 | 41% |
| PPP-09 | IR-10 | 3,06 | 41% |

The ablation results show that there is a clear reduction in ablation debris generation of the printing plate precursors with the IR-dyes of the current invention (PPP-02 to PPP-09, with PPP-05 as reference example) compared to the printing plate precursor including the comparative IR-dye (PPP-01). The ablation level is reduced by more than 30% by using the inventive dyes.

### 3.4 Exposure and development.

The printing plate precursors were image-wise exposed in a range of energy densities from 100 to 220 mJ/cm² with a Creo Trendsetter, a platesetter having a 20 W infrared laser head (830 nm), operating at 140 rpm and 2400dpi, commercially available from Eastman Kodak Corp.

The exposed precursors were then developed in a lab processor device containing THD200 developer, commercially available from Agfa Graphics. The temperature was set at 25°C and the dwell time was 30 s. The printing plates PP-01 to PP-09 were obtained.

### 3.5 Right exposure (RE).

The right exposure (RE) was determined and is defined as the energy density value (mJ/cm2) at which the 2x2 checkerboard pattern reaches a 52% coverage, as measured with a GretagMacBeth D19C densitometer, commercially available from GretagMacbeth AG. The automatic colour filter setting was used.

The results of the RE test are given in Table 4 below.

**Table 4 : RE results**

| Printing plate | RE* mJ/cm² |
|---|---|
| PP-01 *Comp* | 180 |
| PP-02 *Inventive* | 180 |
| PP-03 *Inventive* | 200 |
| PP-04 *Inventive* | 180 |
| PP-05 | 200 |
| PP-06 *Inventive* | 180 |
| PP-07 *Inventive* | 160 |
| PP-08 *Inventive* | 180 |
| PP-09 *Inventive* | 160 |

| | |
|---|---|
| *RE is as defined above | |

The results in Table 4 show that the RE values of the printing plates including the IR-dyes of the present invention PP-02 to PP-09 are similar to the RE value of the printing plate including the comparative IR-dye PP-01.

## Claims

1. A positive-working lithographic printing plate precursor which comprises on a support having a hydrophilic surface or which is provided with a hydrophilic layer, a heat and/or light-sensitive coating including an infrared absorbing compound, **characterized in that** the infrared absorbing compound has a structure according to Formula IV : 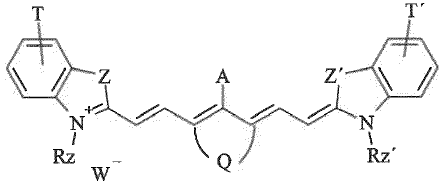 wherein
A represents -S-R¹ wherein R¹ represents a substituted alkyl, aralkyl, alkaryl, cycloalkyl, alkenyl, alkynyl, aryl or heteroaryl group, and/or combinations thereof;
and wherein the alkyl, aralkyl, alkaryl, cycloalkyl, alkenyl, alkynyl, aryl or heteroaryl group is substituted with a thioalkyl group, a thioaryl group, thioheteroaryl, -SH or a thioether group;
Q = -CHR*'*-CHR*"*-, -CR*'*=CR*"*- or -CHR*'*-CHR*"*-CHR*"'*- and R', R" and R*"'* independently represent hydrogen, an alkyl, cycloalkyl, aralkyl, alkaryl, aryl or heteroaryl group, or R' and R" or R" and R"'form together a cyclic structure;
T and T' independently represent hydrogen, alkyl, halogen, alkoxy, cyano, -CO₂Rⁿ, -CONR^{k}R^{m}, -SO₂Rⁿ, -SO₂NR^{o}R^{p} or an optionally substituted annulated benzo ring wherein R^{k}, R^{m} represent hydrogen, an optionally substituted alkyl or aryl group, Rⁿ represents an optionally substituted alkyl or aryl group and R^{o} and R^{p} represent hydrogen, an optionally substituted alkyl or aryl group;
R^{z} and R^{z*'*} independently represent an optionally substituted alkyl group;
Z and Z' independently represent -S-, -CH=CH- or -CR^{a}R^{b}-;
R^{a} and R^{b} represent an optionally substituted alkyl, aralkyl, alkaryl or aryl group; and
W⁻ renders the chromophoric group neutral.

2. A printing plate precursor according to claim 1 wherein R¹ represents an optionally substituted heteroaryl group.

3. A printing plate precursor according to any of the preceding claims wherein the optionally substituted heteroaryl group is represented by Formula III: 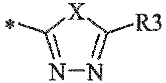
wherein X represents NR², S or O; R² represents hydrogen, an alkyl, cycloalkyl, alkenyl, alkaryl, aralkyl, aryl, heteroaryl or heteroalicyclic group, or combinations thereof; R³
represents hydrogen, an optionally substituted alkyl, alkenyl, S-R⁴, aralkyl, alkaryl, aryl or heteroaryl group, or combinations thereof; R⁴ represents hydrogen, an optionally substituted alkyl, cycloalkyl, alkenyl, alkynyl, aralkyl, alkaryl, aryl, heteroaryl or a heteroalicyclic group and/or combinations thereof;
and wherein * indicates the linking position to S.

4. A printing plate precursor according to any of the preceding claims wherein the optionally substituted heteroaryl group is represented by Formula IV: 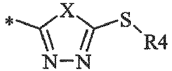 wherein X and R⁴ are as defined in claim 3 and * indicates the linking position to S.

5. A printing plate precursor according to any of the preceding claims wherein the infrared absorbing agent has a structure according to Formula V: 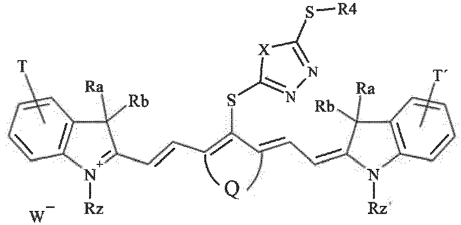 wherin Q, T, T*'*, R^{z}, R^{z*'*}, W⁻, X, R⁴, R^{a} and R^{b} are as defined in the above Formulae.

6. A printing plate precursor according to claims 3 to 5 wherein X= S or O.

7. A printing plate precursor according to claims 4 to 6 wherein R⁴ represents an optionally substituted alkyl, alkenyl, aralkyl, alkaryl, aryl or heteroaryl group and/or combinations thereof.

8. A printing plate precursor according to any of the preceding claims 1 to 7 wherein R^{a} and R^{b} represent an optionally substituted alkyl group.

9. A printing plate precursor according to any of the preceding claims wherein Q represents -CHR^{y}-CHR^{y*'*}-, -CR^{y}=CR^{y*'*}-, or -CH₂-CH₂-CH₂- and the structural element including Q is represented by Formulae VI, VII or VIII: 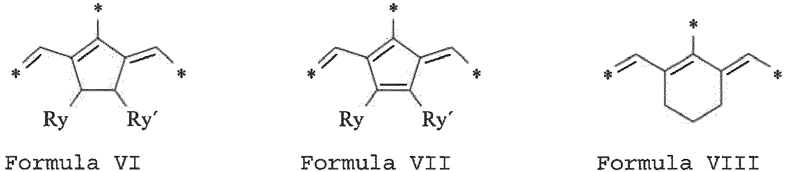 wherein
R^{y} and R^{y*'*} independently represent hydrogen, an optionally substituted alkyl, aralkyl, alkaryl or aryl group or represent the necessary atoms to form a ring; and
* represents the linking positions to the rest of the dye.

10. A printing plate precursor according to any of the preceding claims wherein W⁻ includes a perfluoroalkyl group.

11. A printing plate precursor according to claim 10 wherein the perfluoroalkyl group includes at least 5 fluorine atoms.

12. A printing plate precursor according to any of the preceding claims wherein the coating comprises two layers:
- a first layer comprising a binder including a sulfonamide group, an imide group, a nitrile group, a urea group, a carboxyl group, a sulfonic acid group and/or a phosphoric acid group,
- and a second layer, located above the first layer, comprising the infrared absorbing compound as defined in any of the preceding claims 1 to 11.

13. A method of making a lithographic printing plate precursor including the steps of
- providing a support having a hydrophilic surface or which is provided with a hydrophilic layer;
- applying a coating including the infrared absorbing agent as defined in claims 1 to 11; and
- drying the precursor.

14. A method of making a lithographic printing plate including the steps of
- providing a lithographic printing plate precursor according to any of the preceding claims 1 to 11;
- image-wise exposing the precursor with heat and/or light;
- developing the precursor by treating the precursor with a developing solution thereby removing the exposed areas of the coating from the support.

## Patentansprüche

1. Eine positivarbeitende lithografische Druckplattenvorstufe, die auf einem Träger mit einer hydrophilen Oberfläche oder einem mit einer hydrophilen Schicht versehenen Träger eine wärme- und/oder lichtempfindliche, eine Infrarotlicht absorbierende Verbindung enthaltende Beschichtung umfasst,
**dadurch gekennzeichnet, dass** die Infrarotlicht absorbierende Verbindung eine Struktur gemäß Formel IV aufweist: 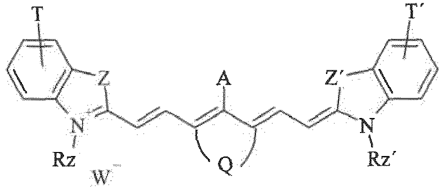 in der
A -S-R¹ bedeutet, wobei R¹ eine substituierte Alkylgruppe, Aralkylgruppe, Alkarylgruppe, Cycloalkylgruppe, Alkenylgruppe, Alkynylgruppe, Arylgruppe oder Heteroarylgruppe und/oder Kombinationen derselben bedeutet,
und wobei die Alkylgruppe, Aralkylgruppe, Alkarylgruppe, Cycloalkylgruppe, Alkenylgruppe, Alkynylgruppe, Arylgruppe oder Heteroarylgruppe durch eine Thioalkylgruppe, eine Thioarylgruppe, eine Thioheteroarylgruppe, -SH oder eine Thioethergruppe substituiert ist,
Q = -CHR*'*-CHR*"*-, -CR'=CR"- oder -CHR*'*-CHR*"*-CHR*"'*- und R', R" und R*"'* unabhängig voneinander ein Wasserstoffatom, eine Alkylgruppe, eine Cycloalkylgruppe, eine Aralkylgruppe, eine Alkarylgruppe, eine Arylgruppe oder eine Heteroarylgruppe bedeuten oder R' und R" oder R" und R"' gemeinsam eine cyclische Struktur bilden, T und T' unabhängig voneinander ein Wasserstoffatom, eine Alkylgruppe, Halogen, eine Alkoxygruppe, eine Cyanogruppe, -CO₂Rⁿ, -CONR^{k}R^{m}, -SO₂Rⁿ, -SO₂NR^{o}R^{p} oder einen gegebenenfalls substituierten anellierten Benzoring bedeuten, wobei R^{k} und R^{m} ein Wasserstoffatom oder eine gegebenenfalls substituierte Alkylgruppe oder Arylgruppe bedeuten, Rⁿ eine gegebenenfalls substituierte Alkylgruppe oder Arylgruppe bedeutet und R^{o} und R^{p} ein Wasserstoffatom oder eine gegebenenfalls substituierte Alkylgruppe oder Arylgruppe bedeuten,
R^{z} und R^{z*'*} unabhängig voneinander eine gegebenenfalls substituierte Alkylgruppe bedeuten,
Z und Z' unabhängig voneinander -S-, -CH=CH- oder -CR^{a}R^{b}-bedeuten,
R^{a} und R^{b} eine gegebenenfalls substituierte Alkylgruppe, Aralkylgruppe, Alkarylgruppe oder Arylgruppe bedeuten, und
W⁻ die chromophore Gruppe neutral macht.

2. Eine Druckplattenvorstufe nach Anspruch 1, wobei R¹ eine gegebenenfalls substituierte Heteroarylgruppe bedeutet.

3. Eine Druckplattenvorstufe nach einem der vorstehenden Ansprüche, wobei die gegebenenfalls substituierte Heteroarylgruppe Formel III entspricht: 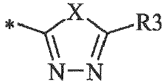
in der X NR², S oder O bedeutet, R² ein Wasserstoffatom, eine Alkylgruppe, eine Cycloalkylgruppe, eine Alkenylgruppe, eine Alkarylgruppe, eine Aralkylgruppe, eine Arylgruppe, eine Heteroarylgruppe oder eine heteroalicyclische Gruppe oder Kombinationen derselben bedeutet, R³ ein Wasserstoffatom, eine gegebenenfalls substituierte Alkylgruppe, Alkenylgruppe, S-R⁴-Gruppe, Aralkylgruppe, Alkarylgruppe, Arylgruppe oder Heteroarylgruppe oder Kombinationen derselben bedeutet, R⁴ ein Wasserstoffatom, eine gegebenenfalls substituierte Alkylgruppe, Cycloalkylgruppe, Alkenylgruppe, Alkynylgruppe, Aralkylgruppe, Alkarylgruppe, Arylgruppe, Heteroarylgruppe oder eine heteroalicyclische Gruppe und/oder Kombinationen derselben bedeutet,
und wobei * die Bindungsstelle an S bedeutet.

4. Eine Druckplattenvorstufe nach einem der vorstehenden Ansprüche, wobei die gegebenenfalls substituierte Heteroarylgruppe Formel IV entspricht: 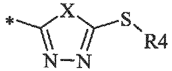 in der X und R⁴ die wie in Anspruch 3 gegebene Definition haben und * die Bindungsstelle an S bedeutet.

5. Eine Druckplattenvorstufe nach einem der vorstehenden Ansprüche, wobei das Infrarotlicht absorbierende Mittel eine Struktur gemäß Formel V aufweist: 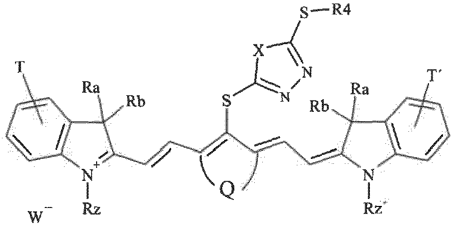 in der Q, T, T*'*, R^{z}, R^{z}*'*, W⁻, X, R⁴, R^{a} und R^{b} die wie in den obigen Formeln gegebene Definition aufweisen.

6. Eine Druckplattenvorstufe nach den Ansprüchen 3 bis 5, wobei X = S oder O.

7. Eine Druckplattenvorstufe nach den Ansprüchen 4 bis 6, wobei R⁴ eine gegebenenfalls substituierte Alkylgruppe, Alkenylgruppe, Aralkylgruppe, Alkarylgruppe, Arylgruppe oder Heteroarylgruppe und/oder Kombinationen derselben bedeutet.

8. Eine Druckplattenvorstufe nach einem der vorstehenden Ansprüche 1 bis 7, wobei R^{a} und R^{b} eine gegebenenfalls substituierte Alkylgruppe bedeuten.

9. Eine Druckplattenvorstufe nach einem der vorstehenden Ansprüche, wobei Q -CHR^{y}-CHR^{y*'*} - , -CR^{y}=CR^{y*'*}- oder -CH₂-CH₂-CH₂- bedeutet und das Q umfassende Strukturelement Formel VI, Formel VII oder Formel VIII entspricht: 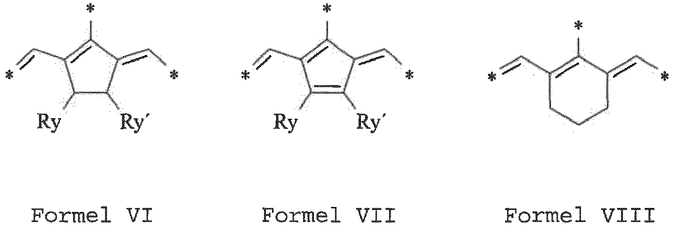 in denen
R^{y} und R^{y'} unabhängig voneinander ein Wasserstoffatom, eine gegebenenfalls substituierte Alkylgruppe, Aralkylgruppe, Alkarylgruppe oder Arylgruppe bedeuten oder die zur Bildung eines Ringes benötigten Atome bedeuten, und
* die Bindungsstellen an den Farbstoffrest bedeutet.

10. Eine Druckplattenvorstufe nach einem der vorstehenden Ansprüche, wobei W⁻ eine Perfluoralkylgruppe umfasst.

11. Eine Druckplattenvorstufe nach Anspruch 10, wobei die Perfluoralkylgruppe mindestens 5 Fluoratome umfasst.

12. Eine Druckplattenvorstufe nach einem der vorstehenden Ansprüche, wobei die Beschichtung zwei Schichten umfasst:
- eine erste Schicht, enthaltend ein Bindemittel, enthaltend eine Sulfonamidgruppe, eine Imidgruppe, eine Nitrilgruppe, eine Harnstoffgruppe, eine Carboxylgruppe, eine Sulfonsäuregruppe und/oder eine Phosphorsäuregruppe,
- und eine zweite, auf die erste Schicht aufgetragene Schicht, enthaltend die wie nach einem der vorstehenden Ansprüche 1 bis 11 definierte Infrarotlicht absorbierende Verbindung.

13. Ein Verfahren zur Herstellung einer lithografischen Druckplattenvorstufe, umfassend die folgenden Schritte:
- Bereitstellen eines Trägers mit einer hydrophilen Oberfläche oder eines mit einer hydrophilen Schicht versehenen Trägers,
- Auftrag einer Beschichtung, die das wie nach einem der Ansprüche 1 bis 11 definierte Infrarotlicht absorbierende Mittel enthält, und
- Trocknen der Vorstufe.

14. Ein Verfahren zur Herstellung einer lithografischen Druckplatte, umfassend die folgenden Schritte:
- Bereitstellen einer lithografischen Druckplattenvorstufe nach einem der vorstehenden Ansprüche 1 bis 11,
- bildweises Erwärmen und/oder Belichten der Vorstufe,
- Entwickeln der Vorstufe durch Behandlung der Vorstufe mit einer Entwicklerlösung, wobei die erwärmten und/oder belichteten Bereiche der Beschichtung vom Träger entfernt werden.

## Revendications

1. Précurseur de plaque d'impression lithographique à effet positif, comprenant sur un support ayant une surface hydrophile ou un support revêtu d'une couche hydrophile un revêtement thermosensible et/ou photosensible contenant un composé absorbant les rayons infrarouges,
**caractérisé en ce que** le composé absorbant les rayons infrarouges présente une structure répondant à la Formule IV: 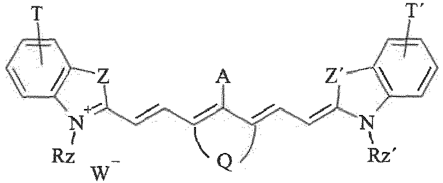 où
A représente -S-R¹, où R¹ représente un groupe alkyle substitué, un groupe aralkyle substitué, un groupe alcaryle substitué, un groupe cycloalkyle substitué, un groupe alcényle substitué, un groupe alcynyle substitué, un groupe aryle substitué ou un groupe hétéroaryle substitué et/ou des combinaisons de ceux-ci,
et où le groupe alkyle, le groupe aralkyle, le groupe alcaryle, le groupe cycloalkyle, le groupe alcényle, le groupe alcynyle, le groupe aryle ou le groupe hétéroaryle est substitué par un groupe thioalkyle, un groupe thioaryle, un groupe thiohétéroaryle, -SH ou un groupe thioéther,
Q = -CHR'-CHR"-, -CR'=CR"- ou -CHR*'*-CHR*"*-CHR*"'*- et R*'*, R*"* et R*"'* représentent, indépendamment l'un de l'autre, un atome d'hydrogène, un groupe alkyle, un groupe cycloalkyle, un groupe aralkyle, un groupe alcaryle, un groupe aryle ou un groupe hétéroaryle ou R' et R" ou R*"* et R*'"* forment conjointement une structure cyclique,
T et T' représentent, indépendamment l'un de l'autre, un atome d'hydrogène, un groupe alkyle, un halogène, un groupe alcoxy, un groupe cyano, -CO₂Rⁿ, - CONR^{k}R^{m}, -SO₂Rⁿ, -SO₂NR^{o}R^{p} ou un noyau benzo condensé éventuellement substitué, où R^{k} et R^{m} représentent un atome d'hydrogène ou un groupe alkyle ou aryle éventuellement substitué, Rⁿ représente un groupe alkyle ou aryle éventuellement substitué et R^{o} et R^{p} représentent un atome d'hydrogène ou un groupe alkyle ou aryle éventuellement substitué,
R^{z} et R^{z'} représentent, indépendamment l'un de l'autre, un groupe alkyle éventuellement substitué,
Z et Z' représentent, indépendamment l'un de l'autre, -S-, - CH=CH- ou -CR^{a}R^{b}- ,
R^{a} et R^{b} représentent un groupe alkyle, aralkyle, alcaryle ou aryle éventuellement substitué, et
W⁻ neutralise le groupe chromophore.

2. Précurseur de plaque d'impression selon la revendication 1, **caractérisé en ce que** R¹ représente un groupe hétéroaryle éventuellement substitué.

3. Précurseur de plaque d'impression selon l'une quelconque des revendications précédentes, **caractérisé en ce que** le groupe hétéroaryle éventuellement substitué répond à la Formule III: 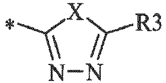 où X représente NR², S ou O, R² représente un atome d'hydrogène, un groupe alkyle, un groupe cycloalkyle, un groupe alcényle, un groupe alcaryle, un groupe aralkyle, un groupe aryle, un groupe hétéroaryle ou un groupe hétéroalicyclique ou des combinaisons de ceux-ci, R³ représente un atome d'hydrogène, un groupe alkyle éventuellement substitué, un groupe alcényle éventuellement substitué, un groupe S-R⁴ éventuellement substitué, un groupe aralkyle éventuellement substitué, un groupe alcaryle éventuellement substitué, un groupe aryle éventuellement substitué ou un groupe hétéroaryle éventuellement substitué ou des combinaisons de ceux-ci, R⁴ représente un atome d'hydrogène, un groupe alkyle éventuellement substitué, un groupe cycloalkyle éventuellement substitué, un groupe alcényle éventuellement substitué, un groupe alcynyle éventuellement substitué, un groupe aralkyle éventuellement substitué, un groupe alcaryle éventuellement substitué, un groupe aryle éventuellement substitué, un groupe hétéroaryle éventuellement substitué ou un groupe hétéroalicyclique et/ou des combinaisons de ceux-ci, et où * représente le site de liaison à S.

4. Précurseur de plaque d'impression selon l'une quelconque des revendications précédentes, **caractérisé en ce que** le groupe hétéroaryle éventuellement substitué répond à la Formule IV: 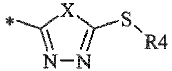 où X et R⁴ ont la définition telle que spécifiée dans la revendication 3 et * représente le site de liaison à S.

5. Précurseur de plaque d'impression selon l'une quelconque des revendications précédentes, **caractérisé en ce que** l'agent absorbant les rayons infrarouges présente une structure répondant à la Formule V: 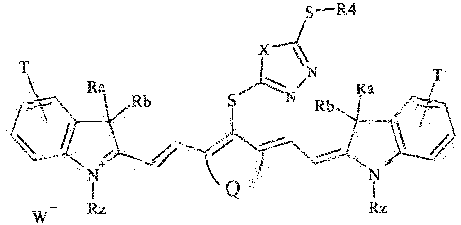 où Q, T, T*'*, R^{z}, R^{z}*'*, W⁻, X, R⁴, R^{a} et R^{b} ont la définition telle que spécifiée dans les formules reprises ci-dessus.

6. Précurseur de plaque d'impression selon les revendications 3 à 5, **caractérisé en ce que** X = S ou O.

7. Précurseur de plaque d'impression selon les revendications 4 à 6, **caractérisé en ce que** R⁴ représente un groupe alkyle éventuellement substitué, un groupe alcényle éventuellement substitué, un groupe aralkyle éventuellement substitué, un groupe alcaryle éventuellement substitué, un groupe aryle éventuellement substitué ou un groupe hétéroaryle éventuellement substitué et/ou des combinaisons de ceux-ci.

8. Précurseur de plaque d'impression selon l'une quelconque des revendications précédentes 1 à 7, **caractérisé en ce que** R^{a} et R^{b} représentent un groupe alkyle éventuellement substitué.

9. Précurseur de plaque d'impression selon l'une quelconque des revendications précédentes, **caractérisé en ce que** Q représente - CHR^{y}-CHR^{y*'*}-, -CR^{y}=CR^{y*'*}- ou -CH₂-CH₂-CH₂- et que l'élément structural comprenant Q répond à la Formule VI, la Formule VII ou la Formule VIII: 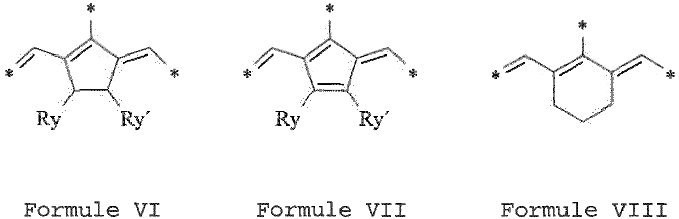 où
R^{y} et R^{y'} représentent, indépendamment l'un de l'autre, un atome d'hydrogène, un groupe alkyle éventuellement substitué, un groupe aralkyle éventuellement substitué, un groupe alcaryle éventuellement substitué ou un groupe aryle éventuellement substitué ou représentent les atomes nécessaires pour former un noyau, et
* représente les sites de liaison au reste du colorant.

10. Précurseur de plaque d'impression selon l'une quelconque des revendications précédentes, **caractérisé en ce que** W⁻ comprend un groupe perfluoroalkyle.

11. Précurseur de plaque d'impression selon la revendication 10, **caractérisé en ce que** le groupe perfluoroalkyle comprend au moins 5 atomes de fluor.

12. Précurseur de plaque d'impression selon l'une quelconque des revendications précédentes, **caractérisé en ce que** le revêtement comprend deux couches:
- une première couche contenant un liant contenant un groupe sulfonamide, un groupe imide, un groupe nitrile, un groupe urée, un groupe carboxyle, un groupe acide sulfonique et/ou un groupe acide phosphorique,
- et une deuxième couche appliquée sur ladite première couche et contenant le composé absorbant les rayons infrarouges tel que défini selon l'une quelconque des revendications précédentes 1 à 11.

13. Procédé pour la confection d'un précurseur de plaque d'impression lithographique, comprenant les étapes consistant à:
- mettre à disposition un support ayant une surface hydrophile ou un support revêtu d'une couche hydrophile,
- appliquer un revêtement contenant l'agent absorbant les rayons infrarouges tel que défini selon l'une quelconque des revendications 1 à 11, et
- sécher le précurseur.

14. Procédé pour la confection d'une plaque d'impression lithographique, comprenant les étapes consistant à:
- mettre à disposition un précurseur de plaque d'impression lithographique selon l'une quelconque des revendications précédentes 1 à 11,
- exposer sous forme d'image ledit précurseur à de la chaleur et/ou à de la lumière,
- développer ledit précurseur en le traitant avec une solution révélatrice permettant d'éliminer du support les zones exposées du revêtement.
